(19) Europäisches Patentamt
European Patent Office
Office européen des brevets

(11) **EP 3 462 200 A1**

(12) **EUROPÄISCHE PATENTANMELDUNG**

(43) Veröffentlichungstag:
03.04.2019 Patentblatt 2019/14

(21) Anmeldenummer: 17193440.9

(22) Anmeldetag: 27.09.2017

(51) Int Cl.:
*G01R 33/00* (2006.01)     *G01R 15/18* (2006.01)
*G01R 15/20* (2006.01)     *G01R 29/08* (2006.01)
*G01R 33/022* (2006.01)    *G01R 33/025* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: SSB Wind Systems GmbH & Co. KG
48499 Salzbergen (DE)

(72) Erfinder: BERTOLOTTI, Fabio
48455 Bad Bentheim (DE)

(74) Vertreter: Bossmeyer, Jörg Peter
Wassermannstrasse 25
49074 Osnabrück (DE)

(54) **BLITZSTROMMESSVORRICHTUNG**

(57)     Blitzstrommessvorrichtung für eine Blitzschutzanlage einer Windkraftanlage, mit einer im Abstand zu einem Blitzableiter (13) angeordneten Sensoranordnung (18), mittels welcher Eigenschaften eines von einem durch den Blitzableiter (13) fließenden Blitzstrom (I) erzeugten Magnetfelds (B) erfassbar sind, und einer mit der Sensoranordnung (18) verbundenen Auswerteeinrichtung (25), mittels welcher unter Auswertung der erfassten Eigenschaften des Magnetfelds (B) der durch den Blitzableiter (13) fließende Blitzstrom (I) bestimmbar oder ermittelbar ist, wobei die Sensoranordnung (18) einen oder mehrere induktive Sensoren (26, 27), mittels welchem oder welchen eine zeitliche Änderung des Magnetfelds (B) erfassbar ist, und einen oder mehrere Magnetfeldsensoren (28, 29) aufweist, mittels welchem oder welchen eine die Stärke des Magnetfelds (B) charakterisierende Größe erfassbar ist.

Fig. 3

## Beschreibung

Die Erfindung betrifft eine Blitzstrommessvorrichtung für eine Blitzschutzanlage einer Windkraftanlage, mit einer im Abstand zu einem Blitzableiter angeordneten Sensoranordnung, mittels welcher Eigenschaften eines von einem durch den Blitzableiter fließenden Blitzstrom erzeugten Magnetfelds erfassbar sind, und einer mit der Sensoranordnung verbundenen Auswerteeinrichtung, mittels welcher unter Auswertung der erfassten Eigenschaften des Magnetfelds der durch den Blitzableiter fließende Blitzstrom bestimmbar oder ermittelbar ist, wobei die Sensoranordnung einen oder mehrere induktive Sensoren aufweist, mittels welchem oder welchen eine zeitliche Änderung des Magnetfelds erfassbar ist.

Blitzschläge sind in der Regel aus einem schnellen Anteil und einem langsamen Anteil zusammengesetzt. In dem schnellen Anteil fließt der Blitzstrom von der Erde zu einer Wolke oder umgekehrt und steigt in wenigen Mikrosekunden auf seinen Spitzenwert an, dessen Stromstärke z.B. bei 6 bis 20 kA liegt, in seltenen Fällen aber auch bis zu 200 kA erreichen kann. Dem schnellen Anteil folgt der langsame Anteil, in welchem die Stromstärke des Blitzstroms auf einen Bruchteil ihres Spitzenwerts abfällt. Der langsame Anteil erstreckt sich aber über eine längere Zeitdauer als der schnelle Anteil, die in einigen Fällen 1 s oder mehr betragen kann. Sowohl der schnelle Anteil als auch der langsame Anteil können die Windkraftanlage oder Teile derselben beschädigen. Die Ursache für solche Beschädigungen liegt bei dem schnellen Anteil an der großen Stromstärke und bei dem langsamen Anteil an der sich über die Zeitdauer ergebenden großen Ladungsmenge.

Eine Windkraftanlage ist in der Regel ein hohes Bauwerk und somit anfällig für Blitzeinschläge. Die Windkraftanlage umfasst mehrere Rotorblätter, die jeweils eine Blitzschutzanlage aufweisen, die wenigstens eine Fangeinrichtung zum Einfangen eines Blitzschlags und eine elektrische Leitung umfasst, welche die Fangeinrichtung mit dem Erdboden verbindet und auch als Blitzableiter bezeichnet wird. Der Blitzableiter ist dabei derart ausgelegt, dass er einen voraussichtlichen Blitzstrom zum Erdboden ableiten kann, ohne dass Schäden an der Windkraftanlage auftreten. Dennoch kann ein Blitzschlag Schäden verursachen, beispielsweise wenn der Blitz nicht direkt in die Fangeinrichtung einschlägt. Daher besteht der Wunsch, Eigenschaften von während der Lebensdauer der Windkraftanlage auftretenden Blitzeinschlägen erfassen zu können. Zur Beschreibung der Eigenschaften eines Blitzeinschlags werden insbesondere die nachfolgend angegebenen Größen herangezogen:

(a) Die Zeit $\tau$, die bis zum Erreichen des Spitzenwerts des Blitzstroms verstreicht.
(b) Der Spitzenwert $I_{max}$ des Blitzstroms.
(c) Die gesamte elektrische Ladung $\int I\,dt$ des Blitzschlags oder Blitzstroms.
(d) Die gesamte Energie $\int I^2\,dt$ des Blitzschlags oder Blitzstroms.

Um diese Größen bestimmen zu können, muss ein durch den Blitzableiter fließendender Blitzstrom mit einem Blitzstrommessgerät erfasst werden. Während eines Blitzschlags können an dem Blitzableiter jedoch hohe Spannungen in Bezug auf den Erdboden auftreten, sodass das Anordnen eines elektrisch mit dem Blitzstrommessgerät verbundenen Sensors in der Nähe des Blitzableiters, wie z.B. bei den in der EP 1 230 556 B1 und der US2011/0102767 A1 beschriebenen Induktionsspulen, das Risiko eines elektrischen Überschlags in das Blitzstrommessgerät erhöht. Unter einem elektrischen Überschlag ist insbesondere das Ausbilden eines stromleitenden Pfads zwischen dem Blitzableiter und dem Sensor und/oder dem Blitzstrommessgerät zu verstehen. Das Risiko eines elektrischen Überschlags wird in der Praxis häufig nicht oder erst nach dem Ergreifen von in der Regel kostenintensiven Gegenmaßnahmen zum Minimieren dieses Risikos akzeptiert. Ferner können induktive Sensoren den im langsamen Anteil des Blitzschlags fließenden Blitzstrom nicht optimal erfassen, was zu Fehlern bei der Bestimmung der oben genannten Größen führt.

Ein alternatives Blitzstrommessgerät wird ebenfalls in der Nähe des Blitzableiters positioniert, verwendet aber elektrisch nicht leitende, faseroptische Leitungen, um den Blitzstrom unter Ausnutzung des magnetooptischen Faraday-Effekts zu erfassen (siehe z.B. EP 2 439 562 A1). Diese optischen Blitzstrommessgeräte sind aber komplex und in der Regel zu teuer für kommerzielle Anwendungen im größeren Umfang. Dies liegt insbesondere an der Anforderung, den Blitzstrom trotz seiner großen Stromstärke-Variation genau messen zu können.

Ausgehend hiervon liegt der Erfindung insbesondere die Aufgabe zugrunde, eine Blitzstrommessvorrichtung der eingangs genannten Art derart weiterzubilden, dass ein im Blitzableiter fließender Blitzstroms mit größerer Genauigkeit erfassbar ist.

Bevorzugt besteht eine Aufgabe der Erfindung auch darin, eine Blitzstrommessvorrichtung zu schaffen, die weit genug von dem Blitzableiter entfernt angeordnet werden kann, sodass das Risiko eines elektrischen Überschlags reduzierbar oder eliminierbar ist.

Je weiter die Blitzstrommessvorrichtung von dem Blitzableiter entfernt angeordnet ist, umso mehr nimmt jedoch die Stärke des von dem in dem Blitzableiter fließenden Blitzstrom erzeugten Magnetfelds ab, sodass mit zunehmendem Abstand zum Blitzableiter die Störanfälligkeit der Messung aufgrund magnetischer Störfelder zunimmt. Eine weitere Aufgabe der Erfindung besteht somit vorzugsweise darin, eine Blitzstrommessvorrichtung zu schaffen, mittels welcher die Störanfälligkeit der Messung aufgrund magnetischer Störfelder reduzierbar oder eliminierbar ist, sodass eine genaue Bestimmung des in dem Blitzableiter fließenden Blitzstroms erzielbar ist.

Vorteilhaft besteht eine zusätzlich Aufgabe der Erfindung darin, eine Blitzstrommessvorrichtung zu schaffen, die aus herkömmlichen und allgemein verfügbaren elektrischen und elektronischen Komponenten aufbaubar ist, sodass die Blitzstrommessvorrichtung mit geringen Kosten herstellbar ist.

Zumindest die zuerst genannte Aufgabe wird erfindungsgemäß durch eine Blitzstrommessvorrichtung nach Anspruch 1 gelöst. Bevorzugte Weiterbildungen der Erfindung sind in den Unteransprüchen und in der nachfolgenden Beschreibung gegeben.

Die eingangs genannte Blitzstrommessvorrichtung für eine Blitzschutzanlage einer Windkraftanlage, mit einer im Abstand zu einem Blitzableiter angeordneten Sensoranordnung, mittels welcher Eigenschaften eines von einem durch den Blitzableiter fließenden Blitzstrom erzeugten Magnetfelds erfassbar sind, und einer mit der Sensoranordnung verbundenen Auswerteeinrichtung, mittels welcher unter Auswertung der erfassten Eigenschaften des Magnetfelds der durch den Blitzableiter fließende Blitzstrom bestimmbar oder ermittelbar ist, wobei die Sensoranordnung einen oder mehrere induktive Sensoren aufweist, mittels welchem oder welchen eine zeitliche Änderung des Magnetfelds erfassbar ist, ist erfindungsgemäß insbesondere dadurch weitergebildet, dass die Sensoranordnung einen oder mehrere Magnetfeldsensoren aufweist, mittels welchem oder welchen eine die Stärke des Magnetfelds charakterisierende Größe erfassbar ist.

Der oder ein Blitzstrom umfasst bevorzugt einen ersten Blitzstromanteil und einen diesem nachfolgenden zweiten Blitzstromanteil, der zeitlich länger andauert als der erste Blitzstromanteil, in welchem sich die Stromstäke des Blitzstroms rascher ändert als im zweiten Blitzstromanteil. Das von dem Blitzstrom erzeugte Magnetfeld verhält sich insbesondere entsprechend oder proportional oder näherungsweise proportional zu dem Blitzstrom. Durch den oder die induktiven Sensoren sind Eigenschaften des Magnetfelds bei einer raschen zeitlichen Änderung des Magnetfelds gut erfassbar, die insbesondere während des ersten Blitzstromanteils auftritt. Durch den oder die Magnetfeldsensoren sind Eigenschaften des Magnetfelds bei einer langsamen zeitlichen Änderung des Magnetfelds gut erfassbar, die insbesondere während des zweiten Blitzstromanteils auftritt. Somit können Eigenschaften des Magnetfelds während oder nahezu während der gesamten Zeitdauer, in welcher der Blitzstrom auftritt, gut erfasst werden, sodass der Blitzstrom mit größerer Genauigkeit bestimmbar oder ermittelbar ist, als wenn nur mit induktiven Sensoren oder nur mit Magnetfeldsensoren gemessen würde.

Bevorzugt ist mit dem oder den induktiven Sensoren auch während des zweiten Blitzstromanteils eine Erfassung von Eigenschaften des Magnetfelds möglich. Vorzugsweise ist mit dem oder den Magnetfeldsensoren auch während des ersten Blitzstromanteils eine Erfassung von Eigenschaften des Magnetfelds möglich. Beispielsweise sind mittels des oder der induktiven Sensoren erfasste Eigenschaften des Magnetfelds mit oder anhand von mittels des oder der Magnetfeldsensoren erfassten Eigenschaften des Magnetfelds ergänzbar und/oder vergleichbar und/oder verifizierbar. Ergänzend oder alternativ sind mittels des oder der Magnetfeldsensoren erfasste Eigenschaften des Magnetfelds z.B. mit oder anhand von mittels des oder der induktiven Sensoren erfassten Eigenschaften des Magnetfelds ergänzbar und/oder vergleichbar und/oder verifizierbar. Somit kann insbesondere die Messgenauigkeit und/oder die Zuverlässigkeit der Blitzstrommessvorrichtung gesteigert werden.

Der Blitzableiter bildet bevorzugt einen Teil der oder einer Blitzschutzanlage. Vorzugsweise umfasst die Blitzschutzanlage den Blitzableiter. Insbesondere ist der Blitzableiter eine elektrische Leitung. Vorteilhaft besteht der Blitzableiter aus Metall. Bevorzugt ist der Blitzableiter elektrisch mit einer Fangeinrichtung verbunden. Vorzugsweise verbindet der Blitzableiter die Fangeinrichtung elektrisch mit dem Erdboden. Vorteilhaft umfasst die Blitzschutzanlage die Fangeinrichtung. Die Fangeinrichtung ist insbesondere zum Einfangen des oder eines Blitzes vorgesehen.

Bevorzugt ist die die Stärke des Magnetfelds charakterisierende Größe die magnetische Flussdichte des Magnetfelds und/oder die magnetische Feldstärke des Magnetfelds. Vorteilhaft entspricht die zeitliche Änderung des Magnetfelds der zeitlichen Änderung der Stärke des Magnetfelds. Vorzugsweise entspricht die zeitliche Änderung des Magnetfelds der zeitlichen Änderung der magnetischen Flussdichte des Magnetfelds und/oder der zeitlichen Änderung der magnetischen Feldstärke des Magnetfelds. Im Vakuum sind die magnetische Flussdichte und die magnetische Feldstärke lediglich durch einen Proportionalitätsfaktor $\mu_0$ miteinander verknüpft, der als Permeabilität des Vakuums bezeichnet wird. Dies gilt oder gilt näherungsweise insbesondere auch für Luft.

Gemäß einer Ausgestaltung ist oder sind der oder die induktiven Sensoren als oder jeweils als Induktionsschleife oder als elektrische Spule ausgebildet, die z.B. auch als Induktionsspule bezeichnet wird. Elektrische Spulen sind relativ kostengünstig herstellbar und/oder auf dem Markt beschaffbar. Bevorzugt ist oder sind der oder die Magnetfeldsensoren als oder jeweils als Hall-Sensor und/oder als magnetoresistiver Sensor ausgebildet. Derartige Sensoren sind auf dem Markt verfügbar und relativ kostengünstig beschaffbar. Vorteilhaft ist von jedem der Sensoren ein Sensorsignal lieferbar und/oder abgebbar. Beispielsweise handelt es sich bei dem oder jedem Sensorsignal um eine elektrische Spannung und/oder um ein elektrisches Spannungssignal.

Bevorzugt weist die oder jede Spule wenigstens eine Wicklung eines elektrischen Stromleiters auf. Der elektrische Stromleiter der wenigsten einen Wicklung der oder jeder Spule ist beispielsweise durch einen Draht oder durch eine, vorzugsweise gedruckte, Leiterbahn gebildet. Vorteilhaft weist die wenigstens eine Wicklung der oder jeder Spule wenigstens eine oder mehrere Windungen auf, die insbesondere durch den oder den jeweiligen elektrischen Stromleiter gebildet ist oder sind. Bevorzugt ist jede Windung der wenigstens einen Wicklung der oder jeder Spule gegenüber einer benachbarten Windung der wenigstens einen Wicklung der oder der jeweiligen Spule elektrisch isoliert. Beispielsweise weist jede Windung der wenigstens einen Wicklung der oder jeder Spule zu einer benachbarten Windung der wenigstens einen Wicklung der oder der jeweiligen Spule einen Abstand auf. Vorteilhaft ist der elektrische Stromleiter der wenigsten einen Wicklung der oder jeder Spule mit einer elektrischen Isolierung ummantelt. Vorzugsweise ist der oder jeder Spule eine Spulenfläche zugeordnet, die insbesondere von der wenigstens einen und/oder durch die wenigstens eine Wicklung der oder der jeweiligen Spule eingeschlossen und/oder umschlossen und/oder begrenzt und/oder definiert ist. Bevorzugt ist der oder jeder Spule und/oder der wenigstens einen Wicklung der oder jeder Spule ein Wicklungssinn zugeordnet. Der Wicklungssinn der oder jeder Spule und/oder der wenigstens einen Wicklung der oder jeder Spule charakterisiert insbesondere die Richtung oder Drehrichtung, entlang welcher der elektrische Stromleiter der wenigstens einen Wicklung der oder der jeweiligen Spule gewickelt oder aufgewickelt ist. Der Wicklungssinn der oder jeder Spule und/oder der wenigstens einen Wicklung der oder jeder Spule entspricht z.B. dem Uhrzeigersinn oder dem Gegenuhrzeigersinn. Bevorzugt ist die Spule oder sind die Spulen auf einer, insbesondere gemeinsamen, Leiterplatte oder Platine angeordnet und/oder vorgesehen und/oder ausgebildet. Vorteilhaft ist die oder jede Spule als Planarspule ausgebildet. Beispielsweise ist der elektrische Stromleiter der wenigsten einen Wicklung der oder jeder Spule durch eine, vorzugsweise gedruckte, Leiterbahn auf der Leiterplatte oder Platine gebildet.

Die Anzahl der induktiven Sensoren beträgt vorzugsweise eins, wenigstens eins, zwei, wenigstens zwei, drei oder wenigstens drei. Bevorzugt beträgt die Anzahl der Magnetfeldsensoren eins, wenigstens eins, zwei, wenigstens zwei, drei oder wenigstens drei. Insbesondere entspricht die Anzahl der Magnetfeldsensoren der Anzahl der induktiven Sensoren. Vorteilhaft sind die Sensoren auf derselben Seite des Blitzableiters angeordnet.

Gemäß einer Weiterbildung bilden die Sensoren ein oder mehrere Sensorpaare, welche den oder jeweils einen der induktiven Sensoren und den oder jeweils einen der Magnetfeldsensoren aufweisen. Bevorzugt sind die Sensoren des oder jedes Sensorpaars in enger räumlicher Nähe zueinander angeordnet. Vorzugsweise weisen die Sensoren des oder jedes Sensorpaars den gleichen oder näherungsweise den gleichen Abstand zu dem Blitzableiter auf. Vorteilhaft sind die Sensoren des oder jedes Sensorpaars auf derselben Seite des Blitzableiters angeordnet. Somit ist insbesondere sichergestellt, dass mittels der Sensoren des oder jedes Sensorpaars Eigenschaften des Magnetfelds am selben Ort oder näherungsweise am selben Ort messbar sind. Die Anzahl der Sensorpaare beträgt vorzugsweise eins, wenigstens eins, zwei, wenigstens zwei, drei oder wenigstens drei. Bevorzugt sind die Sensorpaare auf derselben Seite des Blitzableiters angeordnet.

Gemäß einer Ausgestaltung weisen die Sensorpaare einen unterschiedlichen Abstand zu dem Blitzableiter auf. Insbesondere sind die Sensorpaare entlang einer Geraden, vorzugsweise hintereinander, angeordnet. Vorteilhaft sind die Sensorpaare und/oder ist diese Gerade entlang einer oder in Richtung einer räumlichen Änderung oder einer größten räumlichen Änderung des Magnetfelds oder der Stärke des Magnetfelds angeordnet und/oder ausgerichtet. Vorzugsweise verläuft die Gerade in Richtung eines Gradienten oder Vektorgradienten des Magnetfelds oder der Stärke des Magnetfelds. Da die Stärke des Magnetfelds in räumlicher Hinsicht bevorzugt mit oder näherungsweise mit dem Kehrwert des Abstands zum Blitzableiter abfällt, ergibt sich somit entlang der Geraden und/oder zwischen den Sensorpaaren insbesondere eine relativ große Änderung des Magnetfelds oder der Stärke des Magnetfelds. Dies ist vorteilhaft, da ein magnetisches Störfeld, welches die Messung negativ beeinflusst oder beeinflussen kann, in der Regel durch eine weit entfernte Quelle (wie z.B. ein weit entfernt fließender elektrischer Strom) hervorgerufen wird, sodass das magnetische Störfeld an unterschiedlichen Sensorpaaren gleiche oder nahezu gleiche Eigenschaften aufweist und/oder sich entlang der Geraden linear ändert. Bevorzugt ist mit zwei oder wenigstens zwei oder drei oder wenigstens drei Sensorpaaren das oder ein magnetisches Störfeld identifizierbar und/oder, vorzugsweise zumindest teilweise, eliminierbar oder herausrechenbar. Der Einfluss des oder eines magnetischen Störfelds auf die Messgenauigkeit kann somit deutlich reduziert oder sogar eliminiert werden. Bevorzugt schließen zwei benachbarte Sensorpaare jeweils den gleichen Abstand miteinander ein. Dies ist insbesondere bei mehr als zwei Sensorpaaren sinnvoll. Bei drei Sensorpaaren ist ein mittleres Sensorpaar der Sensorpaare vorzugsweise mittig zwischen zwei äußeren Sensorpaaren der Sensorpaare angeordnet.

Die Gerade, entlang welcher die Sensorpaare vorzugsweise angeordnet sind, verläuft insbesondere durch Mittelpunkte der Sensorpaare und/oder durch Mittelpunkte der induktiven Sensoren und/oder durch Mittelpunkte der Magnetfeldsensoren. Beispielsweise verläuft die Gerade, vorzugsweise mittig, zwischen einer durch Mittelpunkte der induktiven Sensoren verlaufenden ersten Geraden und einer durch Mittelpunkte der Magnetfeldsensoren verlaufenden zweiten Geraden.

Gemäß einer Weiterbildung sind die von den induktiven Sensoren der Sensorpaare gelieferten und/oder abgegebenen Sensorsignale unter Ausbildung eines ersten verknüpften Signals, vorzugsweise linear, miteinander verknüpfbar und die von den Magnetfeldsensoren der Sensorpaare gelieferten und/oder abgegebenen Sensorsignale unter Ausbildung eines zweiten verknüpften Signals, vorzugsweise linear, miteinander verknüpfbar, wobei mittels der Auswerteeinrichtung unter Auswertung der verknüpften Signale der durch den Blitzableiter fließende Blitzstrom bestimmbar und/oder ermittelbar ist. Die Anzahl der Sensorpaare beträgt dabei insbesondere zwei oder wenigstens zwei oder drei oder wenigstens drei. Vorteilhaft ist durch die Bildung der verknüpften Signale, insbesondere bei geeigneter Auslegung der Sensoren, der Einfluss des oder eines magnetischen Störfelds auf die Messung reduzierbar und/oder eliminierbar.

Bevorzugt sind die von den induktiven Sensoren der Sensorpaare gelieferten und/oder abgegebenen Sensorsignale unter Ausbildung des ersten verknüpften Signals derart, vorzugsweise linear, miteinander verknüpfbar, dass ein gleicher konstanter Anteil und/oder eine lineare Abhängigkeit in diesen Sensorsignalen eliminierbar und/oder reduzierbar ist. Dies ist beispielsweise durch Differenzbildung der von den induktiven Sensoren der Sensorpaare gelieferten und/oder abgegebenen Sensorsignale möglich. Das erste verknüpfte Signal ist vorzugsweise ein, insbesondere erstes, Differenzsignal aus den von den induktiven Sensoren der Sensorpaare gelieferten und/oder abgegebenen Sensorsignalen.

Bevorzugt sind die von den Magnetfeldsensoren der Sensorpaare gelieferten und/oder abgegebenen Sensorsignale unter Ausbildung des zweiten verknüpften Signals derart, vorzugsweise linear, miteinander verknüpfbar, dass ein gleicher konstanter Anteil und/oder eine lineare Abhängigkeit in diesen Sensorsignalen eliminierbar und/oder reduzierbar ist. Dies ist beispielsweise durch Differenzbildung der von den Magnetfeldsensoren der Sensorpaare gelieferten und/oder abgegebenen Sensorsignale möglich. Das zweite verknüpfte Signal ist vorzugsweise ein, insbesondere zweites, Differenzsignal aus den von den Magnetfeldsensoren der Sensorpaare gelieferten und/oder abgegebenen Sensorsignalen.

Bevorzugt sind die induktiven Sensoren der Sensorpaare zu einer, insbesondere ersten, Sensorschaltung elektrisch zusammengeschaltet, von welcher das erste verknüpfte Signal bildbar und/oder abgebbar und/oder lieferbar ist. Das Verknüpfen der von den induktiven Sensoren der Sensorpaare gelieferten und/oder abgegebenen Sensorsignale erfolgt somit vorzugsweise durch die, insbesondere erste, Sensorschaltung. Vorteilhaft ist oder umfasst die, insbesondere erste, Sensorschaltung eine Reihenschaltung der induktiven Sensoren der Sensorpaare. Alternativ ist das erste verknüpfte Signal z.B. mittels der Auswerteinrichtung bildbar.

Bevorzugt sind die Magnetfeldsensoren der Sensorpaare zu einer, insbesondere zweiten, Sensorschaltung elektrisch zusammengeschaltet, von welcher das zweite verknüpfte Signal bildbar und/oder abgebbar und/oder lieferbar ist. Das Verknüpfen der von den Magnetfeldsensoren der Sensorpaare gelieferten und/oder abgegebenen Sensorsignale erfolgt somit vorzugsweise durch die, insbesondere zweite, Sensorschaltung. Vorteilhaft ist oder umfasst die, insbesondere zweite, Sensorschaltung eine Reihenschaltung der Magnetfeldsensoren der Sensorpaare. Alternativ ist das zweite verknüpfte Signal z.B. mittels der Auswerteinrichtung bildbar.

Gemäß einer Ausgestaltung ist, insbesondere bei den Sensorpaaren oder bei den beiden Sensorpaaren oder bei zwei oder wenigstens zwei der Sensorpaare, aus den von den induktiven Sensoren der oder der beiden oder der wenigstens zwei Sensorpaare gelieferten und/oder abgegebenen Sensorsignalen das oder ein erstes Differenzsignal bildbar, aus den von den Magnetfeldsensoren der oder der beiden oder der wenigstens zwei Sensorpaare gelieferten und/oder abgegebenen Sensorsignalen das oder ein zweites Differenzsignal bildbar, und mittels der Auswerteeinrichtung unter Auswertung der Differenzsignale der durch den Blitzableiter fließende Blitzstrom bestimmbar und/oder ermittelbar. Durch die Bildung der Differenzsignale ist, insbesondere bei geeigneter Auslegung der Sensoren, der Einfluss des oder eines, vorzugsweise räumlich konstanten, magnetischen Störfelds auf die Messung, reduzierbar und/oder eliminierbar. Das erste Differenzsignal ist oder bildet insbesondere das oder ein erstes verknüpftes Signal. Das zweite Differenzsignal ist oder bildet insbesondere das oder ein zweites verknüpftes Signal.

Bevorzugt sind die induktiven Sensoren der oder der beiden oder die wenigstens zwei Sensorpaare gleich ausgebildet oder bis auf ihren Wicklungssinn gleich ausgebildet. Vorzugsweise weisen die induktiven Sensoren der oder der beiden oder der wenigstens zwei Sensorpaare die gleiche Anzahl an Windungen auf. Die induktiven Sensoren der oder der beiden oder der wenigstens zwei Sensorpaare umschließen und/oder umfassen bevorzugt die gleiche Spulenfläche. Hierdurch wird die Bildung geeigneter Differenzsignale begünstigt. Bevorzugt sind die induktiven Sensoren der oder der beiden oder der wenigstens zwei Sensorpaare mit entgegengesetztem Wicklungssinn versehen. Vorteilhaft sind die induktiven Sensoren der oder der beiden oder der wenigstens zwei Sensorpaare elektrisch in Reihe geschaltet und/oder zu der oder einer, insbesondere ersten, Reihenschaltung elektrisch zusammengeschaltet. Durch diese, insbesondere erste, Reihenschaltung ist es z.B. möglich, das erste Differenzsignal schaltungstechnisch und/oder direkt zu bilden. Insbesondere ist das erste Differenzsignal von dieser, insbesondere ersten, Reihenschaltung bildbar und/oder lieferbar und/oder abgebbar. Alternativ ist das erste Differenzsignal z.B. mittels der Auswerteinrichtung bildbar.

Bevorzugt sind die Magnetfeldsensoren der oder der beiden oder der wenigstens zwei Sensorpaare gleich ausgebildet. Beispielsweise sind die Magnetfeldsensoren der oder der beiden oder der wenigstens zwei Sensorpaare elektrisch in Reihe geschaltet und/oder zu der oder einer, insbesondere zweiten, Reihenschaltung elektrisch zusammengeschaltet. Durch diese, insbesondere zweite, Reihenschaltung ist es z.B. möglich, das zweite Differenzsignal schaltungstechnisch und/oder direkt zu bilden. Insbesondere ist das zweite Differenzsignal von dieser, insbesondere zweiten, Reihenschaltung bildbar und/oder lieferbar und/oder abgebbar. Alternativ ist das zweite Differenzsignal z.B. mittels der Auswerteinrichtung bildbar.

Gemäß einer Weiterbildung umfassen die oder die drei Sensorpaare oder drei der Sensorpaare zwei äußere Sensorpaare und ein zwischen diesen angeordnetes mittleres Sensorpaar, wobei die von den induktiven Sensoren der oder der drei Sensorpaare gelieferten Sensorsignale unter Ausbildung des oder eines ersten verknüpften Signals derart, vorzugsweise linear, miteinander verknüpfbar sind, dass von einer Summe der von den induktiven Sensoren der äußeren Sensorpaare gelieferten und/oder abgegebenen Signale das von dem induktiven Sensor des mittleren Sensorpaars gelieferte und/oder abgegebene Signal oder das Zweifache dieses Signals subtrahierbar ist, und die von den Magnetfeldsensoren der oder der drei Sensorpaare gelieferten und/oder abgegebenen Sensorsignale unter Ausbildung des oder eines zweiten verknüpften Signals derart, vorzugsweise linear, miteinander verknüpfbar sind, dass von einer Summe der von den Magnetfeldsensoren der äußeren Sensorpaare gelieferten und/oder abgegebenen Signale das Zweifache des von dem Magnetfeldsensor des mittleren Sensorpaars gelieferten und/oder abgegebenen Signals subtrahierbar ist. Insbesondere ist dabei mittels der Auswerteeinrichtung unter Auswertung der verknüpften Signale der durch den Blitzableiter fließende Blitzstrom bestimmbar oder ermittelbar. Hierdurch ist vorzugsweise ein sich räumlich und/oder entlang der oder einer Geraden linear änderndes magnetisches Störfeld eliminierbar und/oder reduzierbar. Bevorzugt ist das mittlere Sensorpaar mittig zwischen den äußeren Sensorpaaren angeordnet. Das erste verknüpfte Signal ist vorzugsweise das oder ein, insbesondere erstes, Differenzsignal aus den von den induktiven Sensoren der oder der drei Sensorpaare gelieferten und/oder abgegebenen Sensorsignalen. Das zweite verknüpfte Signal ist vorzugsweise das oder ein, insbesondere zweites, Differenzsignal aus den von den Magnetfeldsensoren der oder der drei Sensorpaare gelieferten und/oder abgegebenen Sensorsignalen.

Bevorzugt sind die induktiven Sensoren der beiden äußeren Sensorpaare gleich ausgebildet. Vorzugsweise weisen die induktiven Sensoren der beiden äußeren Sensorpaare die gleiche Anzahl an Windungen auf. Die induktiven Sensoren der beiden äußeren Sensorpaare umschließen und/oder umfassen bevorzugt die gleiche Spulenfläche. Vorteilhaft sind die induktiven Sensoren der beiden äußeren Sensorpaare mit gleichem Wicklungssinn versehen.

Gemäß einer ersten Alternative sind die induktiven Sensoren der oder der drei Sensorpaare gleich oder bis auf ihren Wicklungssinn gleich ausgebildet. Beispielsweise ist der induktive Sensor des mittleren Sensorpaars mit entgegengesetztem Wicklungssinn wie jeder der induktiven Sensoren der äußeren Sensorpaare versehen.

Gemäß einer zweiten Alternative ist der induktive Sensor des mittleren Sensorpaars derart ausgebildet, dass von ihm bei gleicher Anregung der induktiven Sensoren der oder der drei Sensorpaare ein Sensorsignal lieferbar und/oder abgebbar ist, dessen Betrag doppelt so groß wie der Betrag jedes Sensorsignals ist, das von jedem den induktiven Sensoren der äußeren Sensorpaare abgebbar und/oder lieferbar ist. Beispielsweise ist der induktive Sensor des mittleren Sensorpaars derart ausgebildet, dass von ihm bei gleicher Anregung der induktiven Sensoren der oder der drei Sensorpaare ein Sensorsignal lieferbar und/oder abgebbar ist, dessen Polarität umgekehrt wie die Polarität jedes Sensorsignals ist, das von jedem den induktiven Sensoren der äußeren Sensorpaare abgebbar und/oder lieferbar ist. Der induktive Sensor des mittleren Sensorpaars umschließt und/oder umfasst vorteilhaft die doppelte Spulenfläche wie jeder der induktiven Sensoren der äußeren Sensorpaare. Bevorzugt weist der induktive Sensor des mittleren Sensorpaars die gleiche Anzahl an Windungen wie jeder der induktiven Sensoren der äußeren Sensorpaare auf. Vorteilhaft ist der induktive Sensor des mittleren Sensorpaars mit entgegengesetztem Wicklungssinn wie jeder der induktiven Sensoren der äußeren Sensorpaare versehen. Insbesondere sind die induktiven Sensoren der oder der drei Sensorpaare elektrisch in Reihe geschaltet und/oder zu einer, insbesondere ersten, Reihenschaltung elektrisch zusammengeschaltet. Durch diese, insbesondere erste, Reihenschaltung ist es z.B. möglich, das erste verknüpfte Signal schaltungstechnisch und/oder direkt zu bilden. Insbesondere ist das erste verknüpfte Signal von dieser, insbesondere ersten, Reihenschaltung bildbar und/oder lieferbar und/oder abgebbar. Alternativ ist das erste verknüpfte Signal z.B. mittels der Auswerteinrichtung bildbar.

Bevorzugt sind die Magnetfeldsensoren der oder der drei Sensorpaare gleich ausgebildet. Beispielsweise sind die Magnetfeldsensoren der oder der drei Sensorpaare elektrisch in Reihe geschaltet und/oder zu einer, insbesondere zweiten, Reihenschaltung, elektrisch zusammengeschaltet. Durch diese, insbesondere zweite, Reihenschaltung ist es z.B. möglich, das zweite verknüpfte Signal schaltungstechnisch und/oder direkt zu bilden. Insbesondere ist das zweite verknüpfte Signal von dieser, insbesondere zweiten, Reihenschaltung bildbar und/oder lieferbar und/oder abgebbar. Alternativ ist das zweite verknüpfte Signal z.B. mittels der Auswerteinrichtung bildbar.

Gemäß einer Ausgestaltung ist die Sensoranordnung und/oder sind die Sensorpaare auf der oder einer gemeinsamen Leiterplatte oder Platine angeordnet. Somit ist es möglich, die Sensoranordnung kompakt auszubilden. Insbesondere bildet die Sensoranordnung, vorzugsweise zusammen mit der Leiterplatte oder Platine, eine kompakte bauliche Einheit und/oder ein, insbesondere kompaktes, Sensormodul. Vorteilhaft sind die induktiven Sensoren jeweils als, vorzugsweise auf der Leiterplatte oder Platine angeordnete und/oder vorgesehene, Planarspule und/oder gedruckte Spule ausgebildet. Bevorzugt ist die Sensoranordnung, vorzugsweise zusammen mit der Leiterplatte oder Platine, insbesondere als Ganzes, an der oder einer Windkraftanlage und/oder an einem Rotorblatt der oder einer Windkraftanlage montiert oder montierbar. Vorteilhaft ist die Auswerteeinrichtung oder ein Teil oder zumindest ein Teil der Auswerteeinrichtung auf der Leiterplatte oder Platine, vorzugsweise neben den Sensorpaaren oder zwischen den oder den beiden oder zwischen zwei der Sensorpaare, angeordnet. Somit kann insbesondere die Kompaktheit der Blitzstrommessvorrichtung weiter erhöht werden.

Gemäß einer Weiterbildung umfasst die Auswerteeinrichtung eine Recheneinheit. Bevorzugt ist die Recheneinheit eine digitale Recheneinheit und/oder durch einen Digitalrechner gebildet. Vorzugsweise umfasst die Recheneinheit und/oder der Digitalrechner einen digitalen Signalprozessor. Bevorzugt sind der Recheneinheit das erste verknüpfte Signal oder das erste Differenzsignal und das zweite verknüpfte Signal oder das zweite Differenzsignal zuführbar. Insbesondere ist mittels der Recheneinheit, vorzugsweise unter Auswertung und/oder Verarbeitung des ersten verknüpften Signals oder des ersten Differenzsignals und des zweiten verknüpften Signals oder des zweiten Differenzsignals, der Blitzstrom berechenbar oder bestimmbar oder ermittelbar. Vorzugsweise umfasst die Auswerteeinrichtung und/oder die Recheneinheit einen, insbesondere nicht flüchtigen, Speicher, in welchem der berechnete oder bestimmte oder ermittelte Blitzstrom und/oder der zeitliche Verlauf des berechneten oder bestimmten oder ermittelten Blitzstroms speicherbar ist. Vorteilhaft ist die Auswerteeinrichtung und/oder die Recheneinheit elektrisch mit der Sensoranordnung verbunden.

Gemäß einer Ausgestaltung umfasst die Auswerteeinrichtung und/oder die Recheneinheit einen oder wenigstens einen Integrator, mittels welchem das erste verknüpfte Signal oder das erste Differenzsignal zeitlich integrierbar ist. Somit ist mittels der Auswerteeinrichtung und/oder der Recheneinheit und/oder des Integrators aus dem ersten verknüpften Signal oder dem ersten Differenzsignal insbesondere ein den Blitzstrom charakterisierendes und/oder repräsentierendes Blitzstromsignal berechenbar oder bestimmbar oder ermittelbar. Das den Blitzstrom charakterisierende und/oder repräsentierende Blitzstromsignal wird z.B. auch als finales Schätzwertsignal für den Blitzstrom oder als finaler Schätzwert für den Blitzstrom bezeichnet.

Gemäß einer Weiterbildung ist mittels der Auswerteeinrichtung und/oder der Recheneinheit, insbesondere unter Verwendung eines oder wenigstens eines Konvertierungsfaktors oder Einflusswerts, aus dem ersten verknüpften Signal oder dem ersten Differenzsignal ein erstes Schätzwertsignal für die zeitliche Änderung des Blitzstroms und aus dem zweiten verknüpften Signal oder dem zweiten Differenzsignal ein erstes Schätzwertsignal für den Blitzstrom berechenbar oder bestimmbar oder ermittelbar ist. Der oder der wenigstens eine Konvertierungsfaktor oder Einflusswert ist insbesondere vorbestimmt und wird oder ist beispielsweise, insbesondere vorab, numerisch ermittelt oder ermittelbar oder gemessen oder messbar. Bevorzugt ist mittels der Auswerteeinrichtung und/oder der Recheneinheit aus dem ersten Schätzwertsignal für den Blitzstrom und aus dem ersten Schätzwertsignal für die zeitliche Änderung des Blitzstroms, vorzugsweise unter zeitlicher Integration des ersten Schätzwertsignals für die zeitliche Änderung des Blitzstroms, das oder ein finales Schätzwertsignal für den Blitzstrom oder der oder ein finaler Schätzwert für den Blitzstrom berechenbar oder bestimmbar oder ermittelbar. Das finale Schätzwertsignal für den Blitzstrom oder der finale Schätzwert für den Blitzstrom charakterisiert und/oder repräsentiert insbesondere den Blitzstrom.

Gemäß einer Ausgestaltung umfasst die Auswerteeinrichtung und/oder die Recheneinheit ein, insbesondere analoges oder digitales, Filter. Vorzugsweise umfasst die Auswerteeinrichtung und/oder die Recheneinheit ein Optimalfilter. Beispielsweise umfasst die Auswerteeinrichtung und/oder die Recheneinheit ein Kalman-Filter. Vorteilhaft ist mittels des Filters, z.B. durch eine oder unter Anwendung einer oder wenigstens einer Estimation, der Blitzstrom bestimmbar oder ermittelbar oder berechenbar. Durch ein solches Filter ist der durch den Blitzableiter fließende Blitzstrom insbesondere mit hoher Genauigkeit berechenbar oder bestimmbar oder ermittelbar. Bevorzugt sind mittels des Filters die ersten Schätzwertsignale und/oder das finale Schätzwertsignal oder der finale Schätzwert berechenbar oder bestimmbar oder ermittelbar. Vorteilhaft ist das Filter durch die Recheneinheit und/oder durch den Digitalrechner und/oder durch ein oder wenigstens ein in dieser oder diesem ablaufendes Programm gebildet.

Bevorzugt ist mittels der Auswerteeinrichtung und/oder der Recheneinheit der Beginn eines Blitz-Ereignisses bestimmbar oder ermittelbar. Vorzugsweise ist mittels der Auswerteeinrichtung und/oder der Recheneinheit der maximale Wert oder die maximale Stromstärke des Blitzstroms bestimmbar oder ermittelbar. Vorteilhaft ist mittels der Auswerteeinrichtung und/oder der Recheneinheit eine Anstiegszeit bestimmbar oder ermittelbar, innerhalb welcher der Blitzstrom, insbesondere von dem Beginn des Blitz-Ereignisses an, seinen maximalen Wert oder seine maximale Stromstärke annimmt. Bevorzugt umfasst die Auswerteeinrichtung und/oder der Recheneinheit eine Spitzenwert-Detektor-Einheit, mittels welcher der maximale Wert oder die maximale Stromstärke des Blitzstroms und/oder die Anstiegszeit bestimmbar oder ermittelbar ist oder sind.

Bevorzugt ist mittels der Auswerteeinrichtung und/oder der Recheneinheit, insbesondere durch zeitliche Integration des ermittelten Blitzstroms, eine oder die gesamte Ladung des Blitzschlags und/oder eine oder die gesamte von dem Blitzstrom transportierte Ladung bestimmbar oder ermittelbar. Vorzugsweise umfasst die Auswerteeinrichtung und/oder der Recheneinheit einen Zeit-Integrierer, mittels welchem die vorgenannte Ladung bestimmbar oder ermittelbar ist.

Bevorzugt ist mittels der Auswerteeinrichtung und/oder mittels der Recheneinheit, insbesondere durch zeitliche Integration des Quadrats des ermittelten Blitzstroms, eine oder die gesamte Energie oder spezifische Energie des Blitzschlags und/oder eine oder die gesamte von dem Blitzstroms umgesetzte Energie bestimmbar oder ermittelbar. Vorzugsweise umfasst die Auswerteeinrichtung und/oder die Recheneinheit einen, insbesondere anderen, Zeit-Integrierer, mittels welchem die vorgenannte Energie oder spezifische Energie bestimmbar oder ermittelbar ist.

Bevorzugt umfasst die Auswerteeinrichtung zwei oder wenigstens zwei oder mehrere Analog-Digital-Wandler. Vorzugsweise sind mittels der Analog-Digital-Wandler die von der Sensoranordnung gelieferten und/oder abgegebenen Signale und/oder die von den Sensoren gelieferten und/oder abgegebenen Signale und/oder die von den induktiven Sensoren gelieferten und/oder abgegebenen Signale und/oder die von den Magnetfeldsensoren gelieferten und/oder abgegebenen Signale und/oder das erste verknüpfte Signal oder das erste Differenzsignal und/oder das zweite verknüpfte Signal oder das zweite Differenzsignal digitalisierbar. Bevorzugt sind die Analog-Digital-Wandler zwischen die Sensoren und die Recheneinheit oder das Filter geschaltet. Sofern mehrere der Sensoren zu der oder den Sensorschaltungen oder Reihenschaltungen zusammengeschaltet sind, ist vorzugsweise zwischen die oder jede Sensorschaltung oder Reihenschaltung und die Recheneinheit oder das Filter einer der Analog-Digital-Wandler geschaltet. Alternativ umfasst die Recheneinheit oder das Filter z.B. die Analog-Digital-Wandler. Insbesondere sind die Analog-Digital-Wandler auf der Leiterplatte oder Platine, vorzugsweise neben den Sensorpaaren oder zwischen den oder den beiden oder zwischen zwei der Sensorpaare, angeordnet. Somit können die Sensorsignale kurz hinter den Sensoren digitalisiert werden, sodass die Gefahr eines Einkoppelns von Störungen in die Sensorsignale reduzierbar ist. Bevorzugt ist mittels der Analog-Digital-Wandler oder mittels wenigstens eines ersten der Analog-Digital-Wandler das erste verknüpfte Signal oder das erste Differenzsignal bildbar und/oder abgebbar. Vorteilhaft ist mittels der Analog-Digital-Wandler oder mittels wenigstens eines zweiten der Analog-Digital-Wandler das zweite verknüpfte Signal oder das zweite Differenzsignal bildbar und/oder abgebbar.

Gemäß einer Ausgestaltung ist die Sensoranordnung an oder in dem oder einem Rotorblatt der oder einer Windkraftanlage angeordnet. Insbesondere ist die Leiterplatte oder Platine an oder in dem oder einem Rotorblatt der oder einer Windkraftanlage angeordnet. Vorteilhaft verläuft der oder ein Blitzableiter an oder in dem Rotorblatt. Bevorzugt ist die Fangeinrichtung an oder in dem Rotortblatt und/oder an einer Außenfläche des Rotorblatts angeordnet.

Die Erfindung betrifft ferner eine Windkraftanlage mit einem Maschinenträger, einem am Maschinenträger um eine Rotorachse drehbar gelagerten und ein oder wenigstens ein Rotorblatt oder mehrere Rotorblätter umfassenden Rotor, und einer oder wenigstens einer erfindungsgemäßen Blitzstrommessvorrichtung, deren Sensoranordnung an oder in dem wenigstens einen Rotorblatt oder in wenigstens einem der Rotorblätter angeordnet ist, wobei der Blitzableiter an oder in dem wenigstens einen Rotorblatt verläuft und/oder angeordnet ist.

Die erfindungsgemäße Windkraftanlage kann gemäß allen im Zusammenhang mit der erfindungsgemäßen Blitzstrommessvorrichtung erläuterten Ausgestaltungen weitergebildet sein. Ferner kann die erfindungsgemäße Blitzstrommessvorrichtung gemäß allen im Zusammenhang mit der erfindungsgemäßen Windkraftanlage erläuterten Ausgestaltungen weitergebildet sein.

Die Windkraftanlage umfasst bevorzugt die oder eine Blitzschutzanlage. Vorteilhaft weist die Blitzschutzanlage den Blitzableiter und/oder die oder eine Fangeinrichtung auf. Vorzugsweise weist die Blitzschutzanlage die oder die wenigstens eine Blitzstrommessvorrichtung auf.

Gemäß einer Ausgestaltung ist die Leiterplatte oder Platine und/oder das Sensormodul an oder in dem wenigstens einen Rotorblatt angeordnet. Bevorzugt ist die oder eine Fangeinrichtung an oder in dem wenigstens einen Rotortblatt und/oder an einer Außenfläche des wenigstens einen Rotorblatts angeordnet.

Gemäß einer Weiterbildung umfasst der Rotor eine Rotornabe, an welcher das oder die Rotorblätter gelagert ist oder sind, welches oder welche sich vorzugsweise quer oder näherungsweise quer zur Rotorachse von der Rotornabe weg erstreckt oder erstrecken.

Bevorzugt umfasst die Windkraftanlage einen den Maschinenträger tragenden Turm. Vorteilhaft ist der Turm, insbesondere mit seinem unteren Ende, im Erdboden verankert. Vorzugsweise ist der Maschinenträger am oberen Ende des Turms angeordnet.

Gemäß einer Ausgestaltung umfasst die Windkraftanlage je Rotorblatt eine oder wenigstens eine erfindungsgemäße Blitzstrommessvorrichtung, deren Sensoranordnung an oder in dem jeweiligen Rotorblatt angeordnet ist, an oder in dem der jeweilige Blitzableiter verläuft und/oder angeordnet ist.

Die Erfindung wird nachfolgend anhand bevorzugter Ausführungsformen unter Bezugnahme auf die Zeichnung beschrieben. In der Zeichnung zeigen:

Fig. 1 eine schematische Darstellung einer Windkraftanlage mit einem mehrere Rotorblätter umfassenden Rotor,

Fig. 2 eine schematische Darstellung zur Erläuterung einer Blitzstrommessung,

Fig. 3 eine schematische Darstellung einer Blitzstrommessvorrichtung gemäß einer ersten Ausführungsform,

Fig. 4 eine schematische Darstellung einer Blitzstrommessvorrichtung gemäß einer zweiten Ausführungsform,

Fig. 5 eine grafische Darstellung der Abhängigkeit eines von einem Blitzstrom erzeugten Magnetfelds vom Abstand zum Blitzableiter sowie eines über diesen Abstand räumlich konstanten magnetischen Störfelds,

Fig. 6 eine grafische Darstellung der Abhängigkeit des vom Blitzstrom erzeugten Magnetfelds vom Abstand zum Blitzableiter sowie eines sich mit dem Abstand zum Blitzableiter linear ändernden magnetischen Störfelds und

Fig. 7 eine schematische Darstellung einer Variante der ersten Ausführungsform.

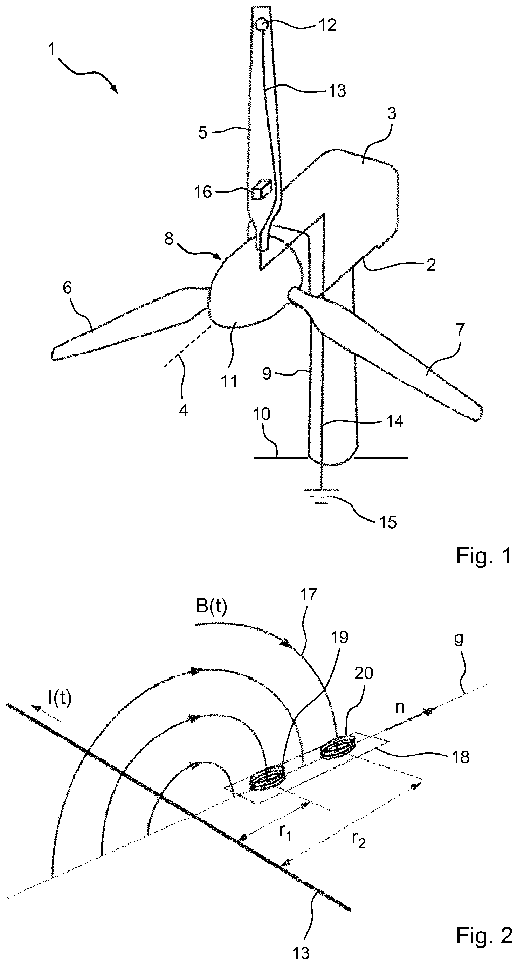

Aus Fig. 1 ist eine schematische Darstellung einer Windkraftanlage 1 ersichtlich, die einen Maschinenträger 2, ein von dem Maschinenträger 2 getragenes Maschinenhaus 3, einem am Maschinenträger 2 um eine Rotorachse 4 drehbar gelagerten und mehrere Rotorblätter 5, 6 und 7 umfassenden Rotor 8 und einen Turm 9 aufweist, der mit seinem unteren Ende im Erdboden 10 verankert ist und an seinem oberen Ende den Maschinenträger 2 trägt. Der Rotor 8 umfasst eine Rotornabe 11, an welcher die Rotorblätter 5, 6 und 7 gelagert sind, die sich quer zur Rotorachse 4 von der Rotornabe 11 weg erstrecken. Dabei sind die Rotorblätter 5, 6 und 7 rings der Rotorachse 4 gleichmäßig verteilt angeordnet.

Die Windkraftanlage 1 umfasst eine Blitzschutzanlage, die eine an einem ersten der Rotorblätter 5 befestigte Fangeinrichtung 12, einen elektrisch mit dieser verbundenen und am ersten Rotorblatt 5 befestigten Blitzableiter 13 und eine elektrische Erdanschlussleitung 14 aufweist, mittels welcher der Blitzableiter 13 elektrisch mit dem Erdboden 10 verbunden ist, was symbolisch durch das Schaltsymbol 15 für Erde gekennzeichnet ist. Benachbart zu dem Blitzableiter 13, aber im Abstand zu diesem, ist eine Blitzstrommessvorrichtung 16 an dem ersten Rotorblatt 5 befestigt. Obwohl nur für das erste Rotorblatt 5 gezeigt, können auch die anderen Rotorblätter 6 und 7 jeweils eine Fangeinrichtung, einen mit der Erdanschlussleitung 14 elektrisch verbundenen Blitzableiter und eine Blitzstrommessvorrichtung aufweisen.

Schlägt ein Blitz in die Fangeinrichtung 12 ein, fließt ein Blitzstrom durch den Blitzableiter 13, der über die Erdanschlussleitung 14 in den Erdboden 10 abgeleitet wird. Der Blitzschlag umfasst dabei einen ersten oder schnellen Anteil und einen diesem nachfolgenden zweiten oder langsamen Anteil, der zeitlich länger andauert als der schnelle Anteil, in welchem sich die Stromstärke des Blitzstroms rascher ändert als im langsamen Anteil.

Aus Fig. 2 ist eine schematische Darstellung zur Erläuterung einer Messung des oder eines durch den Blitzableiter 13 fließenden und zeitlich variierenden Blitzstroms $I(t)$ ersichtlich, wobei die Richtung des Blitzstroms $I(t)$ abhängig von der Art des Blitzes ist (z.B. ein Blitz von einer negativ geladenen Wolke zum Erdboden oder ein Blitz von einer positiv geladenen Wolke zum Erdboden). Der Blitzstrom $I(t)$ erzeugt um den Blitzableiter 13 herum ein elektromagnetisches Feld $\{E_0, B_0\}$, dem sich von dem Blitzableiter 13 radial nach außen erstreckende elektrische Feldlinien (nicht gezeigt) und kreisförmige magnetische Feldlinien 17 zugeordnet oder zuordenbar sind, deren Mittelpunkt am Ort des Blitzableiters 13 liegt. Falls sich der Blitzableiter 13 über eine ausreichende Länge geradlinig erstreckt, ist die Stärke des Magnetfelds $B$ in einer Entfernung $r$ von dem Blitzableiter 13 näherungsweise durch das ampèresche Gesetz gegeben

$$B_0(t, r) = \frac{\mu_0 I(t)}{2\pi r}, \qquad (1)$$

wobei $\mu_0$ der magnetischen Permeabilität des Vakuums und $\pi$ der Kreiszahl entspricht. Die Stärke des Magnetfelds $B$ ist somit insbesondere umgekehrt proportional zur Entfernung $r$. Bei dieser Anordnung nimmt das elektrische Feld $E_0$ ebenfalls mit $1/r$ ab.

Eine Sensoranordnung 18 der oder einer Blitzstrommessvorrichtung umfasst einen oder wenigstens einen ersten elektromagnetischen Feldsensor 19, der in einer vorbestimmten Entfernung $r_1$ von dem Blitzableiter 13 angeordnet ist, und einen oder wenigstens einen zweiten elektromagnetischen Feldsensor 20, der in einer vorbestimmten Entfernung $r_2$ von dem Blitzableiter 13 angeordnet ist, wobei für die Entfernungen $r_1$ und $r_2$ gilt: $r_2 > r_1$. Die elektromagnetischen Feldsensoren 19 und 20 sind vorzugsweise derart ausgebildet, dass sie bei gleicher Anregung ein Signal gleicher Größe oder gleichen Betrags abgeben.

Wenn die elektromagnetischen Feldsensoren (EM-Sensoren) auf die Stärke des magnetischen und/oder des elektrischen Felds am Sensorort ansprechen, wie es z.B. bei Hall-Sensoren der Fall ist, erzeugt der erste Sensor 19 ein erstes elektrisches Signal $h_1$, z.B. in Form eines Spannungssignals, welches indikativ für die Stärke des elektromagnetischen Felds am Ort des ersten elektromagnetischen Sensors 19 ist, und der zweite Sensor 20 erzeugt ein zweites elektrisches Signal $h_2$, z.B. in Form eines Spannungssignals, welches indikativ für die Stärke des elektromagnetischen Felds am Ort des zweiten elektromagnetischen Sensors 20 ist. Bevorzugt weisen das erste Signal $h_1$ und das zweite Signal $h_2$ die gleiche Größe oder den gleichen Betrag auf, wenn die Sensoren 19 und 20 einem räumlich homogenen elektromagnetischen Feld ausgesetzt sind. Darunter ist insbesondere zu verstehen, dass die Signale $h_1$ und $h_2$ identische Größen oder Beträge aufweisen, wenn der erste und der zweite elektromagnetische Feldsensor 19, 20 demselben elektromagnetischen Feld ausgesetzt sind.

Wenn die EM-Sensoren 19 und 20 auf die zeitliche Änderung des magnetischen und/oder des elektrischen Felds am Sensorort ansprechen, wie es z.B. bei Induktionsspulen der Fall ist, erzeugt der erste Sensor 19 ein erstes elektrisches Signal $s_1$, z.B. in Form eines Spannungssignals, welches indikativ für die zeitliche Änderung der Stärke des elektromagnetischen Felds am Ort des ersten elektromagnetischen Sensors 19 ist, und der zweite Sensor 20 erzeugt ein zweites elektrisches Signal $s_2$, z.B. in Form eines Spannungssignals, welches indikativ für die zeitliche Änderung der Stärke des elektromagnetischen Felds am Ort des zweiten elektromagnetischen Sensors 20 ist. Bevorzugt weisen das erste Signal $s_1$ und das zweite Signal $s_2$ die gleiche Größe oder den gleichen Betrag auf, wenn die Sensoren 19 und 20 einem räumlich homogenen, zeitlich variierenden elektromagnetischen Feld ausgesetzt sind. Darunter ist insbesondere zu verstehen, dass die Signale $s_1$ und $s_2$ identische Größen oder Beträge aufweisen, wenn der erste und der zweite elektromagnetische Feldsensor demselben zeitlich variierenden elektromagnetischen Feld ausgesetzt sind.

Mit $n$ wird eine Erfassungsrichtung der Sensoranordnung 18 bezeichnet. Das Symbol $n$ repräsentiert insbesondere einen Einheitsvektor, der entlang einer Geraden g im Raum zeigt, die durch die Mitte des ersten Sensors 19 und durch die Mitte des zweiten Sensors 20 verläuft. Der erste und der zweite Sensor 19 und 20 sind derart angeordnet, dass die Erfassungsrichtung $n$ am Ort des Mittelpunkts zwischen den Sensoren 19 und 20 entlang der oder in Richtung der größten räumlichen Änderung des von dem durch den Blitzableiter 13 fließenden Strom erzeugten elektromagnetischen Felds $\{E_0, B_0\}$ zeigt. In dem Fall, in dem die Sensoren 19 und 20 auf oder hauptsächlich auf eine Komponente des elektromagnetischen Felds ansprechen, wie z.B. auf die magnetische Komponente $B_0$, ist die Erfassungsrichtung $n$ in Richtung des Gradienten von $B_0$ ausgerichtet. Die magnetische Komponente $B_0$ ist oder umfasst insbesondere die magnetische Flussdichte und/oder die magnetische Feldstärke des von dem durch den Blitzableiter 13 fließenden Strom erzeugten Magnetfelds.

Durch die räumliche Änderung der Stärke des von dem durch den Blitzableiter 13 fließenden Strom $I(t)$ erzeugten elektromagnetischen Felds weist das Signal von dem ersten EM-Sensor 19 einen größeren Betrag als das Signal von dem zweiten EM-Sensor 20 auf, was auf die unterschiedliche räumliche Entfernung $r_2 > r_1$ der Sensoren 19 und 20 zu dem Blitzableiter 13 zurückzuführen ist. Zum Berechnen oder Bestimmen des durch den Blitzableiter 13 fließenden Stroms $I(t)$ nutzt die Blitzstrommessvorrichtung vorzugsweise den Unterschied oder die Differenz zwischen den Signalen und/oder zwischen den Beträgen der Signale und insbesondere nicht die Signale oder deren Betrag per se.

Bevorzugt bildet die Blitzstrommessvorrichtung und/oder die Sensoranordnung 18 somit wenigstens einen, bevorzugt aber beide, der nachfolgend angegebenen verknüpften Signale, die in diesem Fall Differenzsignale sind:

$$\phi = s_1 - s_2 \qquad\qquad (2)$$

$$\psi = h_1 - h_2 \qquad\qquad (3)$$

Sowohl das Signal $\phi$, welches auf der zeitlichen Ableitung des Stroms $dI(t)/dt$ basiert, als auch das Signal $\psi$, welches auf dem Strom $I(t)$ basiert, ist proportional zu dem Gradienten des von dem durch den Blitzableiter 13 fließenden Strom $I(t)$ erzeugten elektromagnetischen Felds entlang der Erfassungsrichtung $n$. Da die Stärke des Gradienten eines Felds proportional zur Amplitude oder Stärke des Felds ist (d.h. der Gradienten-Operator ist ein linearer Operator), sind beide Signale indikativ für die Stärke des von dem durch den Blitzableiter 13 fließenden Strom erzeugten elektromagnetischen Felds und somit auch für den durch den Blitzableiter 13 fließenden Strom $I(t)$.

Hervorzuheben ist, dass die beiden Signale $\phi$ und $\psi$ keinen Beitrag von einem äußeren elektromagnetischen Feld enthalten (und somit gegenüber diesem unempfindlich sind), welches die gleiche Stärke am Ort des ersten EM-Sensors 19 und des zweiten EM-Sensors 20 aufweist. Dies ist z.B. der Fall, wenn das äußere Feld im Wesentlichen räumlich homogen ist und daher einen Gradient von null aufweist, was z.B. für das Feld einer weit entfernten Quelle gilt, oder wenn der Gradient des äußeren Felds zwar ungleich null, aber senkrecht zur Erfassungsrichtung $n$ orientiert ist. Durch ein Anordnen der Sensoranordnung 18 in der Weise, dass die Erfassungsrichtung $n$ mit dem Gradienten des interessierenden elektromagnetischen Felds ausgerichtet ist, eliminiert die Blitzstrommessvorrichtung und/oder die Sensoranordnung 18 somit ein, insbesondere unerwünschtes, äußeres elektromagnetisches Feld, welches z.B. eine andere Gradienten-Orientierung als das interessierende elektromagnetische Feld oder einen Gradient von null aufweist. Das interessierende elektromagnetische Feld ist dabei insbesondere dasjenige Feld, welches von dem durch den Blitzableiter 13 fließenden Strom erzeugt wird. Aufgrund der Eliminierung einer durch ein äußeres Feld hervorgerufenen Störung ist es der Blitzstrommessvorrichtung und/oder der Sensoranordnung 18, insbesondere sowohl in dem schnellen Anteil als auch in dem langsamen Anteil des oder eines Blitzschlags, möglich, sich auf das von dem durch den Blitzableiter 13 fließenden Strom erzeugte elektromagnetische Feld zu "fokussieren" und dieses Feld zu messen. Auf diese Thematik wird weiter unten noch einmal eingegangen.

Bevorzugt erzeugt die Sensoranordnung 18 die Differenz $\phi = s_1 - s_2$ selbst, z.B. direkt in ihrer Hardware oder Schaltungsanordnung. Insbesondere sind der erste und der zweite elektromagnetische Feldsensor 19 und 20 als elektrische Spulen oder Induktionsschleifen ausgebildet, die gleiche Spulendurchmesser und Windungsanzahlen aufweisen und räumlich derart ausgerichtet sind, dass sie eine maximale Spannung bei Anwesenheit des von dem durch den Blitzableiter 13 fließenden Strom erzeugten Magnetfelds liefern (maximaler magnetischer Fluss durch die von der Spule umschlossene Fläche). Ferner sind die Windungen der ersten Spule 19 in einer ersten Richtung gewickelt und die Windungen der zweiten Spule 20 in einer der ersten Richtung entgegengesetzten Richtung gewickelt, sodass die erste Spule 19 eine positive Spannung abgibt und die zweite Spule 20 eine negative Spannung abgibt, wenn die Spulen dem gleichen zeitlich variierenden magnetischen Fluss oder der gleichen zeitlich variierenden magnetischen Flussdichte und/oder Feldstärke ausgesetzt sind. Eine elektrische Reihenschaltung der beiden Spulen 19 und 20 erzeugt somit direkt das gewünschte Signal $\phi = s_1 - s_2$.

Das Signal $\phi$, welches indikativ für zeitlichen Ableitung des Stroms $dI(t)/dt$ ist, oder das Signal $\psi$, welches indikativ für den Strom $I(t)$ ist, oder vorzugsweise beide Signale $\phi$ und $\psi$ werden zur Analyse und Verarbeitung an eine Recheneinheit übermittelt. Die Recheneinheit berechnet den Strom $I(t)$ in dem Blitzableiter 13 aus dem Signal $\phi$ oder aus dem Signal $\psi$ oder bevorzugt aus beiden Signalen $\phi$ und $\psi$, insbesondere unter Anwendung des nachfolgend angegebenen Verfahrens, welches vorzugsweise zwei Schritte umfasst:

1. Der aktuelle Strom $I(t)$ in dem Blitzableiter 13 und seine zeitliche Ableitung $dI(t)/dt$ werden aus dem Signal $\phi$ oder aus dem Signal $\psi$ oder aus diesen beiden Signalen $\phi$ und $\psi$, insbesondere unter Verwendung eines vorbestimmten Faktors und/oder Einflusswerts, abgeleitet, der die Amplitude des elektromagnetischen Felds am Sensorort und dessen Gradient mit einem Blitzstrom bekannter Stärke in Beziehung setzt. Dieser vorbestimmte Faktor und/oder Einflusswert wird z.B. analytisch erhalten, beispielsweise durch Invertieren des ampèreschen Gesetzes (1) oder der Maxwell-Gleichungen, insbesondere für die gegebene Geometrie und/oder die interessierenden Randbedingungen, oder experimentell erhalten, beispielsweise durch Messung eines Werts des Signals $\phi$ und/oder eines Werts des Signals $\psi$, welches Signal oder welche Signale durch einen bekannten und in die tatsächliche Hardware und/oder in den Blitzableiter 13 eingespeisten Strom $I(t)$ hervorgerufen wird oder werden. Der vorbestimmte Faktor wird z.B. auch als Konvertierungsfaktor bezeichnet.

2. Das abgeleitete Signal $dI(t)/dt$ wird zeitlich integriert, um den durch den Blitzableiter 13 fließenden Blitzstrom zu ermitteln. Bevorzugt werden sowohl das von $\phi$ abgeleitete Signal $dI(t)/dt$ als auch das von $\psi$ abgeleitete Signal $I(t)$ gemeinsam verwendet, um eine finale Estimation für den Blitzstrom $I(t)$ zu gewinnen, die insbesondere genauer als ein Wert ist, der entweder allein aus dem Signal $\phi$ oder allein aus dem Signal $\psi$ erhalten wird. Ein Kalman-Filter ist ein Beispiel für einen Algorithmus zur Durchführung dieses Verfahren und/oder dieser Estimation. Bevorzugt hat die Blitzstrommessvorrichtung somit die Fähigkeit, den durch den Blitzableiter 13 fließenden Strom $I(t)$ genauer zu bestimmen, als dies entweder mit induktiven Spulen oder mit Hall-Sensoren alleine möglich wäre.

Die zeitliche Variation des Blitzstroms $I(t)$ im Blitzableiter 13 wird in einem, insbesondere nicht flüchtigen, Speicher innerhalb der Recheneinheit in tabellarischer Form gespeichert. Zusätzliche interessierende Größen, wie z. B. der maximale Wert des Blitzstroms $I(t)$ und seine zeitliche Ableitung $dI(t)/dt$ und/oder zeitlich integrierte Größen des Blitzstroms, wie z.B. die gesamte Ladung und die spezifische Leistung, können in der Recheneinheit unter Verwendung des ermittelten Blitzstroms $I(t)$ berechnet und z.B. an eine Steuerungseinrichtung der Windkraftanlage oder an andere vorbestimmte Ziele übermittelt werden. Ferner können zusätzliche Dienste, wie z.B. eine Rotorblatt-Schadens-Estimation, innerhalb der Recheneinheit bereitgestellt werden.

Es können andere oder äußere elektromagnetische Felder gleichzeitig am Ort des ersten Sensors 19 und des zweiten Sensors 20 vorhanden sein. Diese äußeren elektromagnetischen Felder, die hier mit $\{E_1, B_1\}$ bezeichnet werden, können z.B. durch elektrische Geräte oder Anlagenteile erzeugt werden, die in der Nähe der Sensoren 19 und 20 angeordnet sind. Die Blitzstrommessvorrichtung oder die Sensoranordnung 18 eliminiert durch diese äußeren elektromagnetischen Felder hervorgerufene Störungen, die insbesondere unerwünscht sind.

Ohne Einschränkung der Allgemeinheit und lediglich zur Vereinfachung der Beschreibung wird nachfolgend zur Erläuterung der Eliminierung von elektromagnetischen Störungen lediglich das Signal $\phi$ verwendet. Bevorzugt wird das Signal $\psi$ aber ebenfalls und/oder entsprechend verwendet.

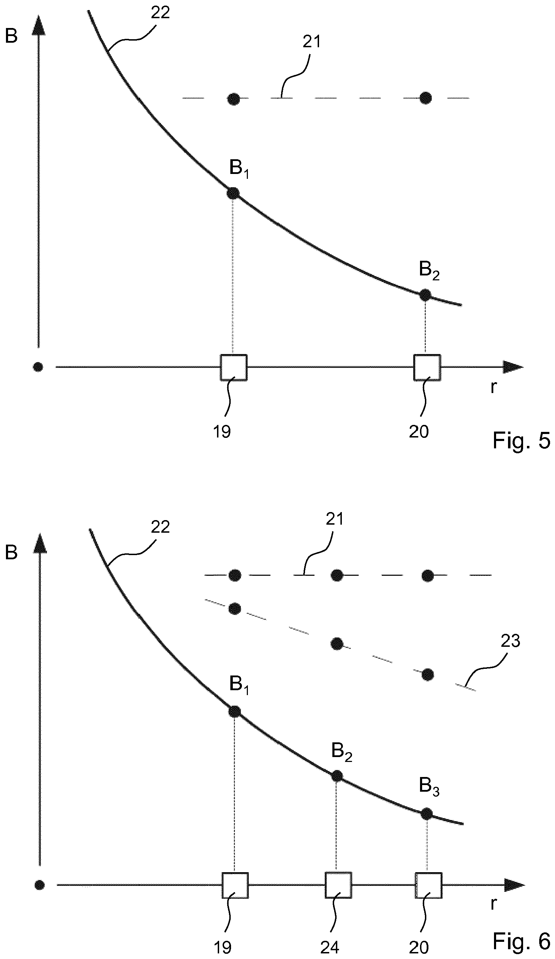

Insbesondere sind zwei Fälle hervorzuheben. In einem ersten Fall, der in Figur 5 veranschaulicht ist, weist das äußere Feld 21 einen konstanten oder im Wesentlichen konstanten Wert entlang der Erfassungsrichtung $n$ am Ort der Sensoranordnung 18 auf, wodurch gleiche Signale an dem ersten EM-Sensor 19 und dem zweiten EM-Sensor 20 erzeugt werden. Dieses äußere Feld 21 tritt entlang der Erfassungsrichtung $n$ zusammen mit dem vom dem durch den Blitzableiter 13 fließenden Strom erzeugten elektromagnetischen Feld 22 auf, wobei die Stärke oder Amplitude des elektromagnetischen Felds 22, welche die mit der Blitzstrommessvorrichtung zu messende Größe ist, mit dem Kehrwert der Entfernung $r$ von dem Blitzableiter 13 abnimmt. Das Differenzsignal $\phi$ eliminiert die durch das äußere Feld 21 hervorgerufene konstante Komponente des überlagerten elektromagnetischen Felds durch die Subtraktion der von den beiden EM-Sensoren 19 und 20 gelieferten Signale.

In einem zweiten Fall, der in Figur 6 veranschaulicht ist, weist das äußere Feld in räumlicher Hinsicht als Komponenten sowohl eine Konstante 21 als auch eine lineare Änderung oder einen linearen Gradient 23 entlang der Erfassungsrichtung $n$ am Ort der Sensoranordnung 18 auf. In diesem Fall umfasst die Sensoranordnung 18 drei Sensoren 19, 20 und 24, die entlang der Erfassungsrichtung $n$ geradlinig ausgerichtet und gleich voneinander beanstandet sind, um das äußere elektromagnetische Feld zu eliminieren. Mit $s_1$ wird das Signal des zum Blitzableiter 13 am nächsten gelegenen Sensors 19, mit $s_3$ das Signal des zum Blitzableiter 13 am entferntesten gelegenen Sensors 20 und mit $s_2$ das Signal des mittleren Sensors 24 bezeichnet, der, insbesondere mittig, zwischen den Sensoren 19 und 20 angeordnet ist. Alle drei Sensoren 19, 20 und 24 erzeugen, insbesondere wenn sie identisch ausgebildet sind, in ihrem jeweiligen Ausgangssignal $s_i$ den gleichen Wert und die gleiche Polarität, wenn jeder individuelle Sensor demselben magnetischen Feld ausgesetzt ist, wobei der Index i eine natürliche Zahl ist und insbesondere die Werte 1, 2 und 3 annehmen kann. Das Differenzsignal $\phi$ wird nun durch folgende Formel gebildet:

$$\phi = s_1 - 2s_2 + s_3 \qquad (4)$$

Somit wird jedes elektromagnetische Feld, welches entweder über die drei Sensoren 19, 20 und 24 konstant ist und/oder in Erfassungsrichtung $n$ linear variiert ein Signal $\phi$ von null erzeugen. Andererseits variiert das von dem durch den Blitzableiter 13 fließenden Strom erzeugte elektromagnetische Feld 22 mit $1/r$ entlang der die drei Sensoren 19, 20 und 24 miteinander verbindenden Geraden, die in Erfassungsrichtung $n$ verläuft. Das Signal $\phi$ ist ungleich null für das Feld 22, da die Signale $s_1$, $s_2$ und $s_3$ in ihrer Amplitude mit $1/r_1$, $1/r_2$ bzw. $1/r_3$ variieren und somit nicht ausgelöscht werden.

Äquivalent kann insbesondere die Aussage getroffen werden, dass $\phi$ in Gleichung (4) eine diskrete Approximation der zweiten räumlichen Ableitung des elektromagnetischen Felds entlang der Erfassungsrichtung $n$ ist (d.h. z. B. der Gradient des Gradienten), sodass Felder, die entweder konstant sind oder einen konstanten Gradienten oder eine räumlich lineare Änderung am Ort der Sensoranordnung 18 aufweisen, zu einem Signal $\phi$ von null führen. Da die erste räumliche Ableitung entlang $n$, wie z.B. durch Gleichung (2) gegeben, und die zweite räumliche Ableitung entlang $n$, wie z.B. durch Gleichung (4) gegeben, linear abhängig von und/oder proportional zu dem Wert des elektromagnetischen Felds selbst sind, folgt, dass das Signal $\phi$ linear abhängig von und/oder proportional zu der Stärke des von dem durch den Blitzableiter 13 fließenden Strom erzeugten elektromagnetischen Felds 22 und somit auch zu dem durch den Blitzableiter 13 fließenden Strom $I(t)$ ist.

Die Eliminierungseigenschaft der Blitzstrommessvorrichtung ist besonders nützlich in Windkraftanlagen, da in der Regel die äußeren elektromagnetischen Felder $\{E_1, B_1\}$ in Rotorblättern von Windkraftanlagen, vorzugsweise zwangsläufig, entweder homogenen sind oder einen lediglich schwachen Gradienten, d.h. eine geringe räumliche Variation, in der Erfassungsrichtung $n$ aufweisen. Diese Aussage basiert insbesondere auf folgenden drei Annahmen:

1. Die Ströme, die das äußere Feld $\{E_1, B_1\}$ erzeugen, verlaufen nicht zwischen dem Blitzableiter 13 und dem ersten EM-Sensor 19 oder dem zweiten EM-Sensor 20, da eine Anordnung von elektrischen Leitungen in diesem Bereich die Gefahr eines Überschlags auf ein nicht akzeptables Niveau erhöhen würde.

2. Die Ströme, die das äußere Feld $\{E_1, B_1\}$ erzeugen, sind viel weiter von dem ersten EM-Sensor 19 und dem zweiten EM-Sensor 20 entfernt als der Blitzableiter 13, sodass sie ein im Wesentlichen räumlich homogenes elektromagnetisches Feld an den Orten des ersten EM-Sensors 19 und des zweiten EM-Sensors 20 erzeugen.

3. Die Ströme, die das äußere Feld $\{E_1, B_1\}$ erzeugen und in der Nähe des ersten Sensors 19 und des zweiten Sensors 20 verlaufen, fließen entweder auf die Sensoranordnung 18 zu oder im Wesentlichen senkrecht zu dem Blitzableiter 13. Diese Annahme ist zu betonen, da elektrische Leitungen, durch welche diese Ströme fließen, dem Blitzableiter 13 nicht näher kommen können, als der erste EM-Sensor 19, und zwar aufgrund des Überschlagrisikos. In dem Fall eines senkrechten Stromflusses weist das äußere elektromagnetische Feld $\{E_1, B_1\}$ einen Gradienten auf, der senkrecht zur Erfassungsrichtung $n$ orientiert ist, sodass lediglich vernachlässigbare Störungen erzeugt werden. In dem Fall eines Stromflusses in Richtung auf die Sensoranordnung 18 zu, muss dieser Stromfluss von einem Stromfluss von der Sensoranordnung 18 weg begleitet sein, sodass die elektromagnetischen Felder, die durch diese Stromflüsse erzeugt werden, sich am Ort der Sensoranordnung 18, insbesondere teilweise oder zumindest teilweise oder vollständig, gegenseitig auslöschen.

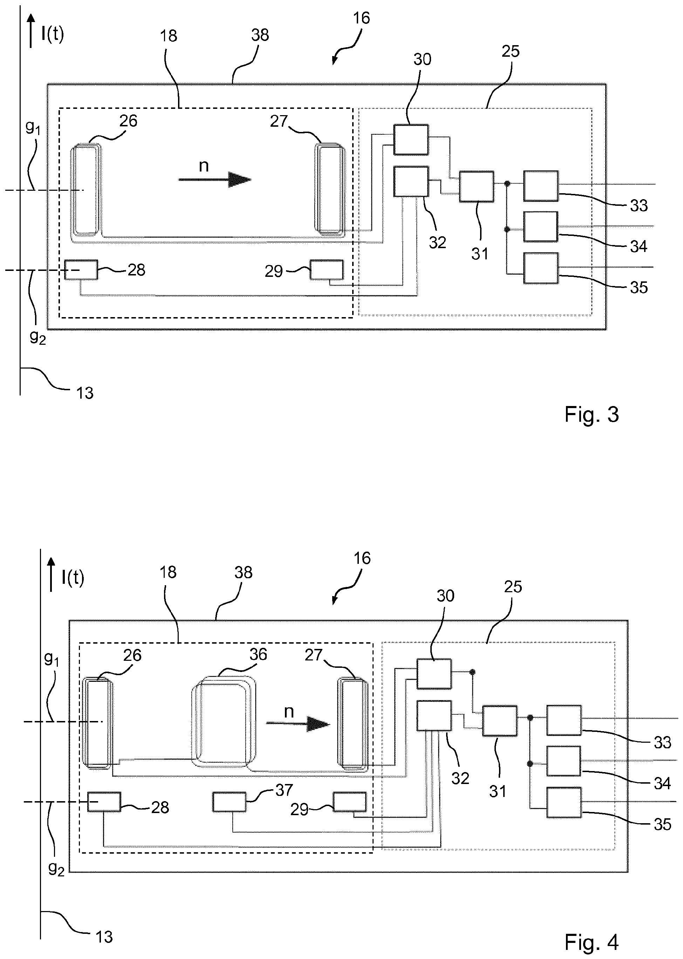

Die in Fig. 1 gezeigte Blitzstrommessvorrichtung 16 umfasst bevorzugt vier oder wenigstens vier elektromagnetische Sensoren, von denen zwei oder wenigstens zwei Sensoren induktive Sensoren sind, die auf eine zeitliche Änderung des magnetischen Felds am jeweiligen Sensorort ansprechen, und zwei oder wenigstens zwei andere Sensoren, Magnetfeldsensoren sind, die auf die Stärke des magnetischen Felds am jeweiligen Sensorort ansprechen. Die für die unter Bezugnahme auf die Fig. 2, 5 und 6 erläuterte Blitzstrommessvorrichtung und/oder Sensoranordnung beschriebenen Zusammenhänge, Erkenntnisse und Ausgestaltungen können auf die Blitzstrommessvorrichtung 16 übertragen werden, die nachfolgend anhand von zwei Ausführungsformen unter Bezugnahme auf die Fig. 3 und 4 beschrieben wird.

Aus Fig. 3 ist eine schematische Darstellung der oder einer Blitzstrommessvorrichtung 16 gemäß einer ersten Ausführungsform ersichtlich, wobei die Blitzstrommessvorrichtung 16 die oder eine Sensoranordnung 18 und eine an diese angeschlossene Auswerteeinrichtung 25 umfasst. Die Sensoranordnung 18 weist einen ersten induktiven Sensor 26, einen zweiten induktiven Sensor 27, einen ersten Magnetfeldsensor 28 und einen zweiten Magnetfeldsensor 29 auf. Die beiden induktiven Sensoren 26 und 27 sind jeweils durch eine elektrische Spule gebildet, und die beiden Magnetfeldsensoren 28 und 29 sind jeweils durch einen Hall-Sensor gebildet. Somit wird der erste induktive Sensor 26 auch als erste Spule, der zweite induktive Sensor 27 auch als zweite Spule, der erste Magnetfeldsensor 28 auch als erster Hall-Sensor und der zweite Magnetfeldsensor 29 auch als zweiter Hall-Sensor bezeichnet. Der erste induktive Sensor 26 und der erste Magnetfeldsensor 28 bilden ein erstes Sensorpaar, und der zweite induktive Sensor 27 und der zweite Magnetfeldsensor 29 bilden ein zweites Sensorpaar. Dabei weisen die Sensoren jedes Sensorpaars den gleichen Abstand zu dem oder einem Blitzableiter 13 auf. Ferner weist das erste Sensorpaar einen geringeren Abstand zu dem Blitzableiter 13 als das zweite Sensorpaar auf. Bevorzugt sind die Sensorpaare entlang einer Geraden angeordnet.

Beispielsweise ist in Analogie zu den aus den Fig. 2 und 5 ersichtlichen Darstellungen der erste elektromagnetische Feldsensor 19 durch das erste Sensorpaar und der zweite elektromagnetische Feldsensor 20 durch das zweite Sensorpaar gebildet, wobei der erste induktive Sensor 26 das Signal $s_1$, der zweite induktive Sensor 27 das Signal $s_2$, der erste Magnetfeldsensor 28 das Signal $h_1$ und der zweite Magnetfeldsensor 29 das Signal $h_2$ liefert, sodass insbesondere die Differenzsignale $\phi$ und $\psi$ bildbar sind.

Die erste Spule 26 und die zweite Spule 27 umfassen oder umschließen die gleiche Spulenfläche und weisen die gleiche Anzahl an Windungen auf. Beispielsweise weisen die Spulen 26 und 27 jeweils einen Durchmesser von 30 mm und 50 Windungen auf. Die beiden Spulen 26 und 27 sind mit einander entgegengesetzten Wicklungssinnen versehen. Die erste Spule 26 umfasst z.B. einen elektrischen Stromleiter, der im Uhrzeigersinn gewickelt oder gewunden ist, und die zweite Spule 27 umfasst z.B. einen elektrischen Stromleiter, der im Gegenuhrzeigersinn gewickelt oder gewunden ist. Bevorzugt weisen die beiden Spulen 26 und 27 zueinander einen Abstand von wenigstens 100 mm oder vorzugsweise von 300 mm auf. Vorteilhaft weisen die beiden Hall-Sensoren 28 und 29 zueinander einen Abstand von wenigstens 100 mm oder vorzugsweise von 300 mm auf. Die Zentren der ersten Spule 26 und zweiten Spule 27 definieren eine erste Gerade $g_1$, und die Zentren des ersten Hall-Sensors 28 und des zweiten Hall-Sensors 29 definieren eine zweite Gerade $g_2$. Die erste Gerade $g_1$ und die zweite Gerade $g_2$ sind in enger räumlicher Nähe zueinander angeordnet und verlaufen parallel zueinander. Ihre gemeinsame Richtung ist durch die Erfassungsrichtung $n$ der Sensoranordnung 18 gekennzeichnet. Da die Spulen 26 und 27 gemäß der ersten Ausführungsform deutlich größer als die Hall-Sensoren 28 und 29 ausgebildet sind, repräsentiert die erste Gerade $g_1$ vorzugsweise die oder näherungsweise die Gerade, entlang welcher die Sensorpaare angeordnet sind.

Die erste Spule 26 und der erste Hall-Sensor 28 sind am nächsten zu dem Blitzableiter 13 positioniert, z.B. in einer Entfernung von 600 mm, sodass sie ein stärkeres Signal von dem oder einem magnetischen Feld, welches von dem oder einem durch den Blitzableiter 13 fließenden Blitzstrom $I(t)$ erzeugt wird, empfangen können als die zweite Spule 27 und der zweite Hall-Sensor 29, die weiter entfernt von dem Blitzableiter 13 positioniert sind, z.B. in einer Entfernung von 900 mm. Die Entfernung der ersten Spule 26 und des ersten Hall-Sensors 28 zu dem Blitzableiter 13 ist aber ausreichend groß, um einen elektrischen Überschlag zwischen dem Blitzableiter 13 und den Sensoren 26 und 28 vermeiden zu können. Die Erfassungsrichtung $n$ ist derart gewählt, dass sie in oder entlang einer, insbesondere gemittelten, Richtung eines Gradienten des magnetischen Felds ausgerichtet ist oder verläuft, welches von dem durch den Blitzableiter 13 fließenden Strom erzeugt wird. Die "gemittelte" Richtung des Gradienten ist insbesondere definiert als das Mittel aus der Richtung des Gradienten an der ersten Spule 26 und der Richtung des Gradienten an der zweiten Spule 27.

Beispielsweise erzeugt ein durch den Blitzableiter fließender Blitzstrom $I(t)$ von 10 kA ein magnetisches Feld $B$ mit einer Stärke von etwa 3 mT (Milli-Tesla) am Ort des ersten Hall-Sensors 28 und mit einer Stärke von etwa 2 mT (Milli-Tesla) am Ort des zweiten Hall-Sensors 29. Die Differenz zwischen dem Signal $h_1$ des ersten Hall-Sensors 28 und dem Signal $h_2$ des zweiten Hall-Sensors 29, nämlich $\psi = h_1 - h_2$, liefert ein Signal, welches indikativ für den Strom $I(t)$ ist. Das Differenzsignal $\psi$ kann auf Hardware-Ebene und/oder in der Sensoranordnung 18 z.B. durch eine Reihenschaltung der Hall-Sensoren 28 und 29 erzeugt werden, oder kann, insbesondere unter Verwendung der individuell abgefragter Hall-Sensor-Signale $h_1$ und $h_2$, numerisch berechnet werden.

Wenn der Strom zeitlich mit der Rate $dI(t)/dt$ variiert, wird von der ersten Spule 26 und von der zweiten Spule 27 jeweils eine Spannung erzeugt, die proportional zu der Rate $dI(t)/dt$ ist. Da die beiden Spulen 26 und 27 in entgegengesetzten Richtungen gewickelt sind, wird mittels einer Reihenschaltung aus der ersten Spule 26 und der zweiten Spule 27 ein Differenzsignal $\phi = s_1 - s_2$ erzeugt, wobei $s_1$ die an der ersten Spule 26 anliegende Spannung und $s_2$ die an der zweiten Spule 27 anliegende Spannung ist oder repräsentiert. Beispielsweise erzeugt ein Stromanstieg von 10 kA pro Millisekunde eine Spannung von etwa 116 V in der ersten Spule 26 und eine Spannung von etwa -78,5 V in der zweiten Spule 27. Das durch die Reihenschaltung erzeugte Differenzsignal $\phi = s_1 - s_2$ liefert somit eine Spannung von 37,5 V. Das Differenzsignal ist insbesondere proportional zu dem Wert von $dI(t)/dt$.

Während eine direkte Erzeugung der Differenzsignale $\phi$ und $\psi$ auf der Hardware-Ebene und/oder in der Sensoranordnung 18 realisierbar ist, ist es alternativ möglich, die Differenzsignale, insbesondere in äquivalenter Weise, numerisch zu berechnen, nachdem jedes individuelle Signal von den Spulen und Hall-Sensoren erfasst und/oder gemessen und aufgezeichnet worden ist.

Zu jeder zeitlichen Instanz $t$ empfängt ein erster Analog-Digital-Wandler 30 (ADC) der Auswerteeinrichtung 25 das Differenzsignal $\phi(t)$ von den Spulen 26 und 27. In einer alternativen Ausführungsform empfängt der erste ADC 30 jedes Spulen-Signal $s_1$ und $s_2$ z.B. unabhängig und bildet das Differenzsignal $\phi = s_1 - s_2$ numerisch. Das Differenzsignal $\phi$ wird an eine Einheit 31 der Auswerteeinrichtung 25 gesendet, wobei die Einheit 31 vorzugsweise einen oder wenigstens einen Integrierer und/oder ein digitales Filter oder Kalman-Filter bildet oder umfasst. Die Einheit 31 kann z.B. auch als Filter oder Filtereinheit oder als Integrier-Einheit bezeichnet werden. Bevorzugt umfasst die Auswerteeinrichtung 25 eine Recheneinheit, welche die Einheit 31 umfasst oder bildet.

Ein zweiter Analog-Digital-Wandler 32 der Auswerteeinrichtung 25 empfängt die individuellen Signale $h_1$ von dem ersten Hall-Sensor 28 und $h_2$ von dem zweiten Hall-Sensor 29 und bildet das Differenzsignal $\psi = h_1 - h_2$ numerisch. Das Differenzsignal $\psi$ wird an die Einheit 31 gesendet.

Die Einheit 31 hat insbesondere Zugriff auf oder verfügt vorzugsweise über einen Konvertierungsfaktor oder Einflusswert, der den Wert des Signals $\psi$ und den Wert des Signals $\phi$ zu einer ersten Estimation des durch den Blitzableiter 13 fließenden Stroms $\hat{I}(t)$ bzw. zu einer ersten Estimation der zeitlichen Änderung des durch den Blitzableiter 13 fließenden Stroms $d\hat{I}(t)/dt$ in Beziehung setzt. Die Vorzeichen (positiv oder negativ) der Signale $\phi$ und $\Psi$ indizieren insbesondere die Richtung des Flusses des Stroms $I(t)$ in dem Blitzableiter 13.

Ein plötzlicher, schneller Anstieg des Signals $\phi(t)$ indiziert z.B. den Beginn eines Blitz-Ereignisses, was insbesondere mittels der Einheit 31 erfassbar ist. Die Erfassung dieses schnellen Anstiegs wird von der Einheit 31 zum Bestimmen eines Startzeitpunkts oder einer Startzeit $t_0$ des Blitz-Ereignisses verwendet. Bevorzugt wird ferner, insbesondere gleichzeitig mit der Bestimmung des Startzeitpunkts oder der Startzeit $t_0$, die Erfassung des schnellen Anstiegs von der Einheit 31 zum Definieren des Beginns eines Integrations-Zeitintervalls verwendet. Die Einheit 31 verwendet das oder ein Zeit-Integral der ersten Estimation der zeitlichen Änderung des Stroms $d\hat{I}(t)/dt$ zusammen mit der ersten Estimation $\hat{I}(t)$ des Stroms, um eine finale Estimation des durch den Blitzableiter 13 fließenden Stroms $\hat{I}(t)$, insbesondere unter Verwendung eines Algorithmus, zu erzeugen, der vorzugsweise ein Kalman-Filter-Algorithmus ist.

Die zeitliche Integration wird fortgesetzt, bis die Werte von $\phi(t)$ und $\psi(t)$ ein Ende des Blitz-Ereignisses indizieren. Der Endzeitpunkt des Blitz-Ereignisses wird insbesondere mit $t_E$ bezeichnet. Die finale Estimation des Stroms $I(t)$ wird in digitaler Form, vorzugsweise in tabellarischer Form, innerhalb der Auswerteeinrichtung 25 gespeichert.

Die finale Estimation des Stroms $I(t)$ wird an eine Spitzenwert-Detektor-Einheit 33 gesendet, mittels welcher sowohl der Spitzenwert des Stroms als auch die Anstiegszeit bis zum Spitzenwert identifizierbar ist. Bevorzugt umfasst oder bildet die Recheneinheit die Spitzenwert-Detektor-Einheit 33.

Die finale Estimation des Stroms $I(t)$ wird ferner an einen, insbesondere zweiten, Zeit-Integrierer 34 gesendet, mittels welchem der Strom $I(t)$ über die Zeit integrierbar ist, sodass ein Wert erzeugbar ist, der indikativ für die gesamte

$$Q = \int_{t_0}^{t_E} I(t)dt$$

Ladung des Blitzschlags und/oder des Blitzstroms ist. Bevorzugt umfasst oder bildet die Recheneinheit den Zeit-Integrierer 34.

Die finale Estimation des Stroms $I(t)$ wird auch zu einem, insbesondere dritten oder anderen, Zeit-Integrierer 35 gesendet, mittels welchem das Quadrat des Stroms $I^2(t)$ über die Zeit integrierbar ist, sodass ein Wert erzeugbar ist,

$$W = \int_{t_0}^{t_E} I^2(t)dt$$

der indikativ für die gesamte spezifische Energie des Blitzschlags und/oder des Blitzstroms ist. Bevorzugt umfasst oder bildet die Recheneinheit den Zeit-Integrierer 35.

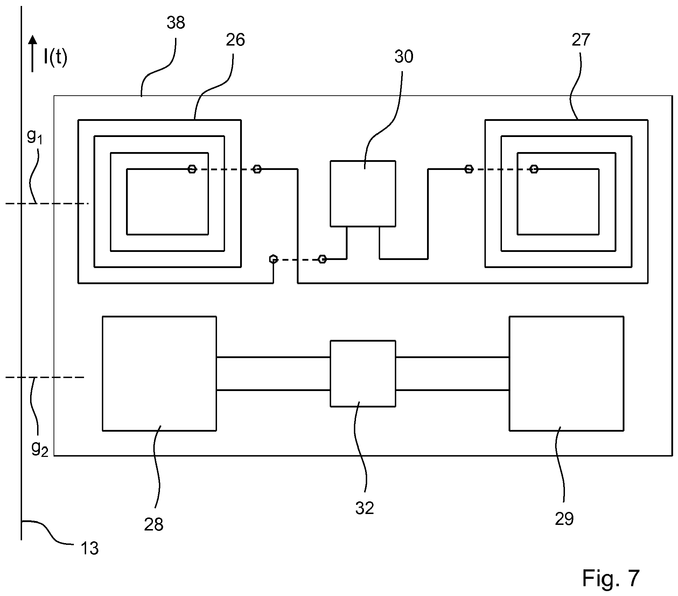

Die Sensoranordnung 18 und/oder die induktiven Sensoren 26 und 27 und die Magnetfeldsensoren 28 und 29 sind auf einer gemeinsamen Leiterplatte oder Platine 38 angeordnet, auf der gemäß der Ausführungsform auch die Auswerteeirichtung 25 angeordnet ist. Gemäß einer Variante der ersten Ausführungsform ist lediglich ein Teil der Auswerteeinrichtung 25 auf der Leiterplatte oder Platine 38 angeordnet. Beispielsweise sind gemäß der Variante der ersten Ausführungsform die Analog-Digital-Wandler 30 und 32, vorzugsweise zwischen den Sensorpaaren, auf der Leiterplatte oder Platine 38 angeordnet, wohingegen die Recheneinheit und/oder die Einheiten 31, 33, 34 und 35 im Abstand zu und/oder entfernt von der Leiterplatte oder Platine 38 angeordnet ist oder sind. Dabei ist die Recheneinheit und/oder die Einheit 31 insbesondere über elektrische Leitungen mit den auf der Leiterplatte oder Platine 38 angeordneten Analog-Digital-Wandlern 30 und 32 verbunden. Eine Sensoranordnung 18 gemäß der Variante der ersten Ausführungsform ist aus Fig. 7 ersichtlich, wobei die im Abstand und/oder entfernt von der Leiterplatte oder Platine 38 angeordnete Recheneinheit und/oder die im Abstand und/oder entfernt von der Leiterplatte oder Platine 38 angeordneten Einheiten 31, 33, 34 und 35 nicht dargestellt sind. Ferner ist aus Fig. 7 erkennbar, dass die induktiven Sensoren 26 und 27 jeweils als, vorzugsweise gedruckte, Planarspule ausgebildet sind. Die gestrichelt dargestellten Leiterbahnen, die insbesondere zum Verbinden der Spulen 26 und 27 untereinander und mit dem Analog-Digital-Wandler 30 dienen, verlaufen z.B. auf der aus Fig. 7 nicht ersichtlichen Rückseite der Leiterplatte oder Platine 38 oder über Drahtbrücken. Die Sensoranordnung gemäß Fig. 7 bildet insbesondere ein Sensormodul.

Aus Fig. 4 ist eine schematische Darstellung einer Blitzstrommessvorrichtung 16 gemäß einer zweiten Ausführungsform ersichtlich, wobei zu der ersten Ausführungsform identische oder ähnliche Merkmale mit denselben Bezugzeichen wie bei der ersten Ausführungsform bezeichnet sind. Die Blitzstrommessvorrichtung 16 umfasst die oder eine Sensoranordnung 18 und eine an diese angeschlossene Auswerteeinrichtung 25, wobei die Sensoranordnung 18 einen ersten induktiven Sensor 26, einen zweiten induktiven Sensor 36, einen dritten induktiven Sensor 27, einen ersten Magnetfeldsensor 28, einen zweiten Magnetfeldsensor 37 und einen dritten Magnetfeldsensor 29 aufweist. Die drei induktiven Sensoren 26, 27 und 36 sind jeweils durch eine elektrische Spule gebildet, und die drei Magnetfeldsensoren 28, 29 und 37 sind jeweils durch einen Hall-Sensor gebildet. Somit wird der erste induktive Sensor 26 auch als erste Spule, der zweite induktive Sensor 36 auch als zweite Spule, der dritte induktive Sensor 27 auch als dritte Spule, der erste Magnetfeldsensor 28 auch als erster Hall-Sensor, der zweite Magnetfeldsensor 37 auch als zweiter Hall-Sensor und der dritte Magnetfeldsensor 29 auch als dritter Hall-Sensor bezeichnet. Der erste induktive Sensor 26 und der erste Magnetfeldsensor 28 bilden ein erstes Sensorpaar, der zweite induktive Sensor 36 und der zweite Magnetfeldsensor 37 bilden ein zweites Sensorpaar und der dritte induktive Sensor 27 und der dritte Magnetfeldsensor 29 bilden ein drittes Sensorpaar. Dabei weisen die Sensoren jedes Sensorpaars den gleichen Abstand zu dem oder einem Blitzableiter 13 auf. Ferner weist das erste Sensorpaar einen geringeren Abstand zu dem Blitzableiter 13 als das zweite Sensorpaar auf, welches einen geringeren Abstand zu dem Blitzableiter 13 als das dritte Sensorpaar aufweist. Insbesondere ist das zweite Sensorpaar mittig zwischen dem ersten Sensorpaar und dem dritten Sensorpaar angeordnet. Bevorzugt sind die Sensorpaare entlang einer Geraden angeordnet.

Die erste Spule 26 und die dritte Spule 27 umfassen oder umschließen die gleiche Spulenfläche $A_1$ und weisen die gleiche Anzahl an Windungen auf. Beispielsweise weisen die erste Spule 26 und eine dritte Spule 27 jeweils einen Durchmesser von 30 mm und 50 Windungen auf. Die zweite Spule 36 weist die gleiche Anzahl an Windungen wie die erste Spule 26 und der dritte Spule 27 auf. Ferner umfasst oder umschließt die zweite Spule 36 eine Spulenfläche $A_2$, die doppelt so groß wie die Fläche $A_1$ ist, die von der ersten Spule 26 und/oder der dritten Spule 27 umschlossen oder umfasst ist. Die erste Spule 26 und die dritte Spule 27 sind mit gleichen Wicklungssinnen versehen. Ferner ist die zweite Spule 36 mit einem dem Wicklungssinn der ersten Spule 26 und/oder der dritten Spule 27 entgegengesetzten Wicklungssinn versehen. Die erste Spule 26 und die dritte Spule 27 umfassen z.B. jeweils einen elektrischen Stromleiter, der im Uhrzeigersinn gewickelt oder gewunden ist, und die zweite Spule 36 umfasst z.B. einen elektrischen Stromleiter, der im Gegenuhrzeigersinn gewickelt oder gewunden ist. Bevorzugt weisen die erste Spule 26 und die zweite Spule 37 einen Abstand zueinander von wenigstens 200 mm oder von vorzugsweise 300 mm auf. Die zweite Spule 36 ist mittig zwischen der ersten Spule 26 und der dritten Spule 27 angeordnet, wobei der Mittelpunkt von allen drei Spulen 26, 27 und 36 auf einer Geraden $g_1$ liegt, deren Richtung die Erfassungsrichtung $n$ beschreibt. Der erste Hall-Sensor 28, der zweite Hall-Sensor 37 und der dritte Hall-Sensor 29 sind ebenfalls gleich voneinander beanstandet und entlang einer zweiten Geraden $g_2$ angeordnet, wobei der zweite Hall-Sensor 37 mittig zwischen den anderen beiden Hall-Sensoren 28 und 29 angeordnet ist und wobei die Richtung der zweiten Geraden $g_2$ ebenfalls in oder entlang der Erfassungsrichtung $n$ weist oder verläuft. Da die Spulen 26, 27 und 36 gemäß der zweiten Ausführungsform deutlich größer als die Hall-Sensoren 28, 29 und 37 ausgebildet sind, repräsentiert die erste Gerade $g_1$ vorzugsweise die oder näherungsweise die Gerade, entlang welcher die Sensorpaare angeordnet sind.

Beispielsweise ist in Analogie zu der aus Fig. 6 ersichtlichen Darstellungen der elektromagnetische Feldsensor 19 durch das erste Sensorpaar, der elektromagnetische Feldsensor 24 durch das zweite Sensorpaar und der elektromagnetische Feldsensor 20 durch das dritte Sensorpaar gebildet, wobei der erste induktive Sensor 26 das Signal $s_1$, der zweite induktive Sensor 36 das Signal $s_2$, der dritte induktive Sensor 27 das Signal $s_3$, der erste Magnetfeldsensor 28 das Signal $h_1$, der zweite Magnetfeldsensor 37 das Signal $h_2$ und der dritte Magnetfeldsensor 29 das Signal $h_3$ liefert, sodass insbesondere die Differenzsignale $\phi$ und $\psi$ bildbar sind.

Wenn der Strom zeitlich mit der Rate $dI(t)/dt$ variiert, wird eine Spannung $s_1$ an der ersten Spule 26, eine Spannung $s_2$ an der zweiten Spule 36 und eine Spannung $s_3$ an der dritten Spule 27 erzeugt, wobei die Spannungen proportional zu der Rate $dI(t)/dt$ sind. Da die zweite Spule 36 in die entgegengesetzte Richtung wie die erste Spule 26 und die dritte Spule 29 gewickelt oder gewunden ist, erzeugt eine Reihenschaltung aus der ersten, der zweiten und der dritten Spule direkt das Differenzsignal $\phi = s_1 - 2s_2 + s_3$, wobei $s_1$, $s_2$ und $s_3$ die an der ersten Spule 26, an der zweiten Spule 36 bzw. an der dritten Spule 27 anliegenden Spannungen sind. Da die zweite Spule 36 die doppelte Spulenfläche $A_2$ wie die erste Spule 26 und/oder die zweite Spule 27 umschließt oder umfasst, ist das Signal $\phi$ insbesondere äquivalent zu der Gleichung (4). Das Signal $\phi$ wird einem ersten Analog-Digital-Wandler 30 zugeführt.

Jedes der Signale $h_1$, $h_2$ und $h_3$ von dem ersten Hall-Sensor 28, dem zweiten Hall-Sensor 37 bzw. dem dritten Hall-Sensor 29 wird individuell von einem zweiten Analog-Digital-Wandlern 32 abgefragt, und das Differenzsignal $\psi = h_1 - 2h_2 + h_3$ wird, vorzugsweise von dem zweiten Analog-Digital-Wandlern 32, numerisch berechnet.

Die Auswerteeinrichtung 25 und die Verarbeitung der Signale $\phi$ und $\psi$ stimmt insbesondere mit der ersten Ausführungsform überein, sodass zur weiteren Beschreibung der zweiten Ausführungsform auf die Beschreibung der ersten Ausführungsform verwiesen wird.

Die Sensoranordnung 18 und/oder die induktiven Sensoren 26, 27 und 36 und die Magnetfeldsensoren 28, 29 und 37 sind auf einer gemeinsamen Leiterplatte oder Platine 38 angeordnet, auf der auch die Auswerteeirichtung 25 angeordnet ist. Gemäß einer Variante der zweiten Ausführungsform ist lediglich ein Teil der Auswerteeinrichtung 25 auf der Leiterplatte oder Platine 38 angeordnet. Beispielsweise sind die Analog-Digital-Wandler 30 und 32 auf der Leiterplatte oder Platine 38 angeordnet, wohingegen die Einheiten 31, 33, 34 und 35 entfernt von der Leiterplatte oder Platine 38 angeordnet sind.

Bezugszeichenliste

| 1 | Windkraftanlage |
|---|---|
| 2 | Maschinenträger |
| 3 | Maschinenhaus |
| 4 | Rotorachse |
| 5 | Rotorblatt |
| 6 | Rotorblatt |
| 7 | Rotorblatt |
| 8 | Rotor |
| 9 | Turm |
| 10 | Erdboden |
| 11 | Rotornabe |
| 12 | Fangeinrichtung |
| 13 | Blitzableiter |
| 14 | Erdanschlussleitung |
| 15 | Erde (Symbol) |
| 16 | Blitzstrommessvorrichtung |
| 17 | magnetische Feldlinien |
| 18 | Sensoranordnung |
| 19 | elektromagnetischer Feldsensor |
| 20 | elektromagnetischer Feldsensor |
| 21 | äußeres Feld / magnetisches Störfeld |
| 22 | elektromagnetisches Feld / Magnetfeld |
| 23 | äußeres Feld / magnetisches Störfeld |
| 24 | elektromagnetischer Feldsensor |
| 25 | Auswerteeinrichtung |
| 26 | induktiver Sensor / Spule |
| 27 | induktiver Sensor / Spule |
| 28 | Magnetfeldsensor / Hall-Sensor |
| 29 | Magnetfeldsensor / Hall-Sensor |
| 30 | Analog-Digital-Wandler |
| 31 | Integrier-Einheit / Recheneinheit |
| 32 | Analog-Digital-Wandler |
| 33 | Spitzenwert-Detektor-Einheit |
| 34 | Zeit-Integrierer |
| 35 | Zeit-Integrierer |
| 36 | induktiver Sensor / Spule |
| 37 | Magnetfeldsensor / Hall-Sensor |
| 38 | Platine / Leiterplatte |
| I(t) | Blitzstrom |
| n | Erfassungsrichtung |
| g | Gerade |

**Patentansprüche**

**1.** Blitzstrommessvorrichtung für eine Blitzschutzanlage einer Windkraftanlage, mit einer im Abstand zu einem Blitzableiter (13) angeordneten Sensoranordnung (18), mittels welcher Eigenschaften eines von einem durch den Blitzableiter (13) fließenden Blitzstrom (I) erzeugten Magnetfelds (B) erfassbar sind, und einer mit der Sensoranordnung (18) verbundenen Auswerteeinrichtung (25), mittels welcher unter Auswertung der erfassten Eigenschaften des Magnetfelds (B) der durch den Blitzableiter (13) fließende Blitzstrom (I) bestimmbar oder ermittelbar ist, wobei die Sensoranordnung (18) einen oder mehrere induktive Sensoren (26, 27) aufweist, mittels welchem oder welchen eine zeitliche Änderung des Magnetfelds (B) erfassbar ist, **dadurch gekennzeichnet, dass** die Sensoranordnung (18) einen oder mehrere Magnetfeldsensoren (28, 29) aufweist, mittels welchem oder welchen eine die Stärke des Magnetfelds (B) charakterisierende Größe erfassbar ist.

2.  Blitzstrommessvorrichtung nach Anspruch 1, **dadurch gekennzeichnet, dass** die die Stärke des Magnetfelds (B) charakterisierende Größe die magnetische Flussdichte oder die magnetische Feldstärke des Magnetfelds (B) ist.

3.  Blitzstrommessvorrichtung nach Anspruch 1 oder 2, **dadurch gekennzeichnet, dass** der oder die induktiven Sensoren (26, 27) als oder jeweils als elektrische Spule ausgebildet ist oder sind.

4.  Blitzstrommessvorrichtung nach einem der vorangehenden Ansprüche, **dadurch gekennzeichnet, dass** der oder die Magnetfeldsensoren (28, 29) als oder jeweils als Hall-Sensor oder als magnetoresistiver Sensor ausgebildet ist oder sind.

5.  Blitzstrommessvorrichtung nach einem der vorangehenden Ansprüche, **dadurch gekennzeichnet, dass** die Sensoren (26, 27, 28, 29) mehrere Sensorpaare (26, 28; 27, 29) bilden, welche jeweils einen der induktiven Sensoren und jeweils einen der Magnetfeldsensoren aufweisen, wobei die Sensoren jedes Sensorpaars (26, 28; 27, 29) den gleichen oder näherungsweise den gleichen Abstand zu dem Blitzableiter (13) aufweisen.

6.  Blitzstrommessvorrichtung nach Anspruch 5, **dadurch gekennzeichnet, dass** die Sensorpaare (26, 28; 27, 29) entlang einer Geraden ($g_1$) angeordnet sind und einen unterschiedlichen Abstand zu dem Blitzableiter (13) aufweisen.

7.  Blitzstrommessvorrichtung nach Anspruch 6, **dadurch gekennzeichnet, dass** die Gerade ($g_1$) in Richtung einer größten räumlichen Änderung der Stärke des Magnetfelds (B) ausgerichtet ist.

8.  Blitzstrommessvorrichtung nach einem der Ansprüche 5 bis 7, **dadurch gekennzeichnet, dass** aus den von den induktiven Sensoren der Sensorpaare (26, 28; 27, 29) gelieferten Sensorsignalen ein erstes Differenzsignal ($\phi$) bildbar ist, aus den von den Magnetfeldsensoren der Sensorpaare (26, 28; 27, 29) gelieferten Sensorsignalen ein zweites Differenzsignal ($\psi$) bildbar ist und mittels der Auswerteeinrichtung (25) unter Auswertung der Differenzsignale ($\phi$, $\psi$) der durch den Blitzableiter (13) fließende Blitzstrom (I) bestimmbar oder ermittelbar ist.

9.  Blitzstrommessvorrichtung nach einem der Ansprüche 5 bis 8, **dadurch gekennzeichnet, dass** die induktiven Sensoren der Sensorpaare (26, 28; 27, 29) gleich oder bis auf ihren Wicklungssinn gleich ausgebildet sind.

10. Blitzstrommessvorrichtung nach einem der Ansprüche 5 bis 9, **dadurch gekennzeichnet, dass** die induktiven Sensoren der Sensorpaare (26, 28; 27, 29) elektrisch in Reihe geschaltet sind.

11. Blitzstrommessvorrichtung nach einem der Ansprüche 5 bis 10, **dadurch gekennzeichnet, dass** die Sensorpaare (26, 28; 27, 29) auf einer gemeinsamen Leiterplatte oder Platine (38) angeordnet sind.

12. Blitzstrommessvorrichtung nach Anspruch 11, **dadurch gekennzeichnet, dass** die Auswerteeinrichtung (25) eine Recheneinheit (31) und mehrere zwischen die Sensoren und die Recheneinheit (31) geschaltete Analog-Digital-Wandler (30, 32) aufweist, die auf der Leiterplatte oder Platine (38) zwischen den Sensorpaaren (26, 28; 27, 29) angeordnet sind.

13. Blitzstrommessvorrichtung nach Anspruch 11 oder 12, **dadurch gekennzeichnet, dass** die induktiven Sensoren (26, 27) jeweils als auf der Leiterplatte oder Platine (38) angeordnete Planarspule ausgebildet sind.

14. Windkraftanlage mit einem Maschinenträger (2), einem am Maschinenträger (2) um eine Rotorachse (4) drehbar gelagerten und wenigstens ein Rotorblatt (5) umfassenden Rotor (8), **gekennzeichnet durch** wenigstens eine Blitzstrommessvorrichtung (16) nach einem der vorangehenden Ansprüche, wobei die Sensoranordnung (18) der Blitzstrommessvorrichtung (16) an oder in dem wenigstens einen Rotorblatt (5) angeordnet ist, an oder in welchem der Blitzableiter (13) verläuft.

Fig. 1

Fig. 2

Fig. 3

Fig. 4

Fig. 5

Fig. 6

Fig. 7

Europäisches Patentamt

European Patent Office

Office européen des brevets

**EUROPÄISCHER RECHERCHENBERICHT**

Nummer der Anmeldung

EP 17 19 3440

| | **EINSCHLÄGIGE DOKUMENTE** | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X | US 2009/167301 A1 (AUSSERLECHNER UDO [AT]) 2. Juli 2009 (2009-07-02) * Abbildungen 4-5 * * Absätze [0001] - [0002] * * Absatz [0013] * * Absätze [0016] - [0018] * * Absätze [0046] - [0060] * ----- | 1-14 | INV. G01R33/00 G01R15/18 G01R15/20 G01R29/08 ADD. G01R33/022 G01R33/025 |
| X | US 2012/029853 A1 (BAUMHEINRICH THORSTEN FRANK [DE] ET AL) 2. Februar 2012 (2012-02-02) * Abbildungen 1-5 * * Absätze [0019] - [0022] * * Absätze [0030] - [0033] * ----- | 1-14 | |
| X | US 2012/290240 A1 (FUKUI HIROFUMI [JP]) 15. November 2012 (2012-11-15) * Abbildungen 2-4 * * Absätze [0031] - [0049] * ----- | 1-14 | |
| A | KARRER N ET AL: "A NEW CURRENT MEASURING PRINCIPLE FOR POWER ELECTRONIC APPLICATIONS", 11TH. INTERNATIONAL SYMPOSIUM ON POWER SEMICONDUCTOR DEVICES AND IC S. ISPSD 99. PROCEEDINGS. TORONTO, MAY 26 - 28, 1999; [INTERNATIONAL SYMPOSIUM ON POWER SEMICONDUCTOR DEVICES & IC'S], NEW YORK, NY : IEEE, US, 26. Mai 1999 (1999-05-26), Seiten 279-282, XP000903590, ISBN: 978-0-7803-5291-9 * das ganze Dokument * ----- | 1-3 | RECHERCHIERTE SACHGEBIETE (IPC) G01R F03D |

-/--

Der vorliegende Recherchenbericht wurde für alle Patentansprüche erstellt

| Recherchenort | Abschlußdatum der Recherche | Prüfer |
|---|---|---|
| München | 28. März 2018 | Danisi, Alessandro |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
....................................................................
& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 17 19 3440

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2003/112000 A1 (SORENSON JR THOMAS [IE]) 19. Juni 2003 (2003-06-19) * Abbildungen 1, 3 * * Absätze [0013] - [0022] * * Absatz [0047] * | 1,3, 5-11,13 | |
| A | US 2014/253108 A1 (SINGH BRIJ N [US] ET AL) 11. September 2014 (2014-09-11) * das ganze Dokument * | 1-4,12, 13 | |
| A | US 2012/271564 A1 (DUDLEY KENNETH L [US] ET AL) 25. Oktober 2012 (2012-10-25) * Abbildungen 5, 8 * * Absätze [0023], [0035] * | 1-14 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 28. März 2018 | Danisi, Alessandro |

EPO FORM 1503 03.82 (P04C03)

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

Seite 2 von 2

## ANHANG ZUM EUROPÄISCHEN RECHERCHENBERICHT
## ÜBER DIE EUROPÄISCHE PATENTANMELDUNG NR.

EP 17 19 3440

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-03-2018

| Im Recherchenbericht angeführtes Patentdokument | Datum der Veröffentlichung | Mitglied(er) der Patentfamilie | Datum der Veröffentlichung |
|---|---|---|---|
| US 2009167301 A1 | 02-07-2009 | DE 102008061067 A1<br>US 2009167301 A1 | 27-08-2009<br>02-07-2009 |
| US 2012029853 A1 | 02-02-2012 | CN 102788893 A<br>CN 107085137 A<br>DK 2525460 T3<br>EP 2525460 A1<br>US 2012029853 A1 | 21-11-2012<br>22-08-2017<br>10-02-2014<br>21-11-2012<br>02-02-2012 |
| US 2012290240 A1 | 15-11-2012 | CN 102841232 A<br>JP 5834292 B2<br>JP 2012251993 A<br>US 2012290240 A1 | 26-12-2012<br>16-12-2015<br>20-12-2012<br>15-11-2012 |
| US 2003112000 A1 | 19-06-2003 | AT 313806 T<br>AU 4871801 A<br>DE 60116079 T2<br>EP 1277060 A1<br>ES 2255549 T3<br>US 2003112000 A1<br>WO 0179869 A1 | 15-01-2006<br>30-10-2001<br>31-08-2006<br>22-01-2003<br>01-07-2006<br>19-06-2003<br>25-10-2001 |
| US 2014253108 A1 | 11-09-2014 | CN 105190322 A<br>EP 2965096 A1<br>US 2014253108 A1<br>WO 2014137432 A1 | 23-12-2015<br>13-01-2016<br>11-09-2014<br>12-09-2014 |
| US 2012271564 A1 | 25-10-2012 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- EP 1230556 B1
- US 20110102767 A1

- EP 2439562 A1